# EUROPEAN PATENT SPECIFICATION

(11) **EP 2 624 280 B1**
(45) Date of publication and mention of the grant of the patent: **04.09.2019**
(21) Application number: 11828615.2
(22) Date of filing: 29.07.2011
(51) Int. Cl.: H01L 21/02, B23K 20/00, H01L 21/67, B32B 37/00

(54) **NORMAL-TEMPERATURE BONDING DEVICE AND NORMAL-TEMPERATURE BONDING METHOD**
VORRICHTUNG ZUR BINDUNG BEI NORMALER TEMPERATUR UND VERFAHREN ZUR BINDUNG BEI NORMALER TEMPERATUR
DISPOSITIF DE COLLAGE À TEMPÉRATURE NORMALE ET PROCÉDÉ DE COLLAGE À TEMPÉRATURE NORMALE

(30) Priority: 28.09.2010 JP 2010217441
(43) Date of publication of application: 07.08.2013
(73) Proprietor: Mitsubishi Heavy Industries Machine Tool Co., Ltd., Shiga, 520-3080 (JP)
(72) Inventor: TSUNO, Takeshi, Tokyo 108-8215 (JP); GOTO, Takayuki, Tokyo 108-8215 (JP); KINOUCHI, Masato, Tokyo 108-8215 (JP); IDE, Kensuke, Tokyo 108-8215 (JP)
(74) Representative: Studio Torta S.p.A.
(86) International application number: PCT/JP2011/067424
(87) International publication number: WO 2012/043054

(56) References cited:
- JP-A- 2007 005 335
- JP-A- 2007 201 196
- JP-A- 2007 281 166
- US-A1- 2007 111 471
- US-A1- 2008 153 258
- US-A1- 2010 231 928

## Description

### Technical Field

The present invention is related to a room temperature bonding apparatus and a room temperature bonding method, especially, to a room temperature bonding apparatus and a room temperature bonding method, which are used to bond a plurality of substrates.

### Background Art

MEMS (Micro Electro-Mechanical System) is known in which minute electrical parts and mechanical parts are integrated. As the MEMS, a micro-machine, a pressure sensor, a micro motor and so on are exemplified. A technique of the room temperature bonding is known in which activated wafers are brought into contact in a vacuum ambience and the wafers are bonded. Such room temperature bonding is suitable to produce the MEMS. The MEMS formed by bonding the wafers with large warpage sometimes becomes a defective product. It is desired to produce devices with good quality stably.

In JP 2003-318219A, a mounting method is disclosed in which bonding planes can be cleaned efficiently and uniformly with energy waves or energy particles, and the impurity absorption through etching of an opposing chamber wall can be avoided in case of cleaning in the chamber. In the mounting method, the energy waves or the energy particles are emitted between bonded objects opposing to each other from a single irradiation means to clean the bonding planes substantively simultaneously, and one of the bonded objects is rotated during the cleaning, and the bonded objects are bonded after alignment of the cleaned bonded objects.

In JP 2006-73780A is disclosed a room temperature bonding method by which it is possible to bond without warpage. The room temperature bonding method in which the bonding is carried out after surface activation processing of the bonding planes of bonded objects by energy wave, an atomic beam, an ion beam or plasma, includes preliminary bonding at a room temperature and heating for substantially bonding.

### Citation List

[Patent Literature 1] JP 2003-318219A
[Patent Literature 2] JP 2006-73780A
[Patent Literature 3] US 2007/111471
[Patent Literature 4] JP 2007 201196
[Patent Literature 5] US 2010/231928
[Patent Literature 6] US 2008/153258

### Summary of the Invention

One object of the present invention is to provide a room temperature bonding apparatus and a room temperature bonding method, in which the quality of a product produced by bonding objects can be improved.

Another object of the present invention is to provide a room temperature bonding apparatus and a room temperature bonding method, in which the product can be produced stably, by using the bonding of objects.

Still another object of the present invention is to provide a room temperature bonding apparatus and a room temperature bonding method, in which the product can be produced at higher speed, by using the bonding of objects.

The room temperature bonding apparatus of the present invention is defined in the appended claims 1-7.

According to such a room temperature bonding apparatus, the residual stress of the bonding resultant substrate can be reduced and the quality can be improved.

The room temperature bonding apparatus of the present invention is further provided with a control unit. The heat chamber is provided with a pressurization mechanism configured to pressurize the bonding resultant substrate. The control unit controls the pressurization mechanism to pressurize the bonding resultant substrate when the bonding resultant substrate is annealed. According to such a room temperature bonding apparatus, the bonding resultant substrate can be formed to have a predetermined shape.

The room temperature bonding apparatus of the present invention is further provided with a sensor configured to measure the load applied to the bonding resultant substrate when the bonding resultant substrate is annealed. The control unit controls the pressurization mechanism such that the load does not exceed a predetermined load. Such a room temperature bonding apparatus can prevent that the bonding resultant substrate breaks by increasing the load applied to the bonding resultant substrate.

The room temperature bonding apparatus of the present invention is further provided with a chamber in which desorption of absorption material from the two substrates is carried out before activating the two substrate. According to such a room temperature bonding method, it is possible to prevent voids from generating in the bonding plane of the bonding resultant substrate when the bonding resultant substrate is annealed and the bonding strength of the bonding resultant substrate can be improved.

A room temperature bonding apparatus of the present invention is further provided with a cooling unit configured to cool the two substrates after desorption of the absorption material from the two substrates is carried out. The control unit controls the bonding chamber such that the two substrates are activated after the two substrates are cooled.

The heat chamber is also used as the chamber where desorption of the absorption material from the two substrates is carried out before activating the two substrates. Such a room temperature bonding apparatus is desirably compact in size, compared with another room temperature bonding apparatus in which a chamber which anneals the bonding resultant substrate and a chamber for desorption of the absorption material from the two substrates are different.

The heat chamber includes a first holding device configured to hold a first substrate as one of the two substrates; a second holding device configured to hold a second substrate as the other of the two substrates; a first heater configured to carry out desorption of the absorption material from the first substrate, when said first holding device holds the first substrate; and a second heater configured to carry out desorption of the absorption material from the second substrate when said second holding device holds the second substrate. When the bonding resultant substrate is annealed by the first heater, the control unit controls the pressurization mechanism such that the bonding resultant substrate is sandwiched and pressured by the first holding device and the second holding device.

The room temperature bonding method of the present invention is defined in the appended claims 8-14.

According to such a room temperature bonding method, the residual stress of the bonding resultant substrate can be reduced and the quality can be further improved.

The room temperature bonding method of the present invention is further provided with a step of pressurizing the bonding resultant substrate while the annealing is carried out to the bonding resultant substrate. According to such a room temperature bonding method, the bonding resultant substrate can be formed to have a predetermined shape.

The room temperature bonding method of the present invention is further provided with a step of measuring a load to pressurize the bonding resultant substrate when the bonding resultant substrate is annealed; and a step of controlling the pressure such that the rises pressure to a predetermined pressure or above. According to such a room temperature bonding method, it is possible to prevent that the bonding resultant substrate breaks that the load applied to the bonding resultant substrate increases.

The room temperature bonding method of the present invention is further provided with a step of carrying out desorption of absorption material from the two substrates before the step of activating the two substrates. According to such a room temperature bonding method, it is possible to prevent voids from generating in the bonding plane of the bonding resultant substrate when the bonding resultant substrate is annealed, and the bonding strength of the bonding resultant substrate can be improved.

The room temperature bonding method of the present invention is further provided with a step of cooling the two substrates after a step of carrying out desorption of the absorption material from the two substrates. The two substrates are activated after the cooling. According to such a room temperature bonding method, a product can be produced at higher speed and the throughput can be improved.

The bonding resultant substrate is annealed by using the heat chamber for carrying out desorption of the absorption material from the two substrates. A main portion of the room temperature bonding apparatus which executes such a room temperature bonding method is compact in size and desirable, compared with a main portion of another room temperature bonding apparatus in which a unit for annealing the bonding resultant substrate is different from a unit for carrying out desorption of the absorption material from the two substrates.

The heat chamber is provided with a first holding device which holds a first substrate as one of the two substrates; a second holding device which holds a second substrate as the other of the two substrates; a first heater for carrying out desorption of the absorption material from the first substrate when the first holding device holds the first substrate; and a second heater for carrying out desorption of the absorption material from the second substrate when the second holding device holds the second substrate. The bonding resultant substrate is pressurized between the first holding device and the second holding device and the annealing is carried out by the first heater.

The room temperature bonding apparatus and the room temperature bonding method of the present invention can reduce the residual stress of a product produced by bonding objects and it is possible to improve the quality of product.

### Brief Description of the Drawings

FIG. 1 is a sectional view showing a main portion of a room temperature bonding apparatus;
FIG. 2 is a sectional view showing a bonding chamber;
FIG. 3 is a sectional view showing a heat chamber;
FIG. 4 is a plan view showing an upper cartridge;
FIG. 5 is a sectional view showing the upper cartridge;
FIG. 6 is a plan view showing a lower cartridge;
FIG. 7 is a sectional view showing the lower cartridge;
FIG. 8 is a block diagram showing the configuration of a control unit of the room temperature bonding apparatus;
FIG. 9 is a flow chart showing a room temperature bonding method of the present invention;
FIG. 10 is a sectional view showing another heat chamber;
FIG. 11 is a sectional view showing another heat chamber;
FIG. 12 is a sectional view showing another heat chamber;
FIG. 13 is a sectional view showing another main portion of the room temperature bonding apparatus; and
FIG. 14 is a sectional view showing another main portion of the room temperature bonding apparatus.

### Description of Embodiments

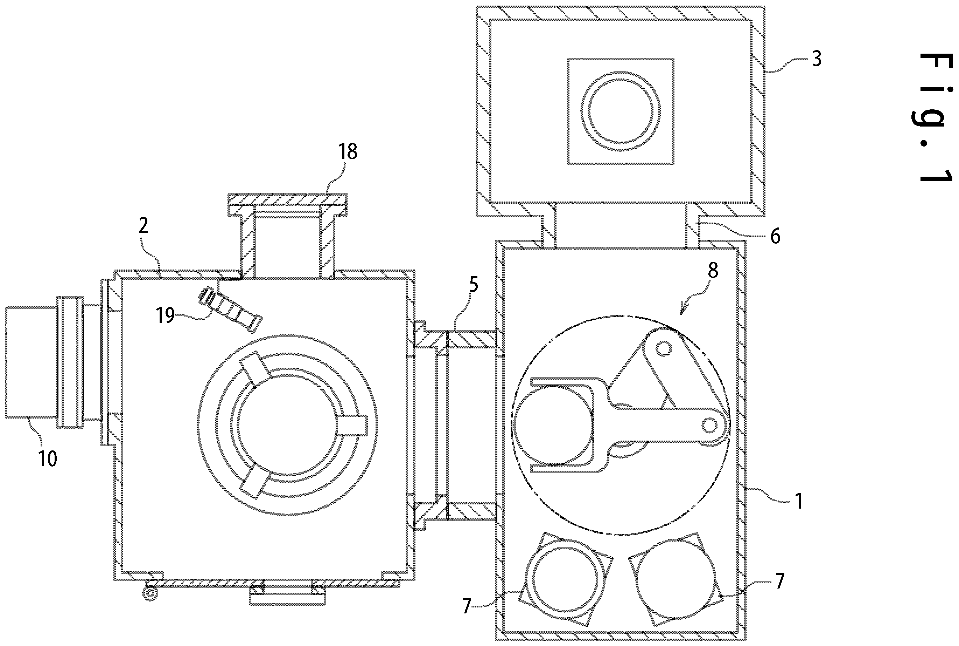

Hereinafter, the room temperature bonding apparatus according to embodiments of the present invention will be described with reference to the drawings. The room temperature bonding apparatus is provided with a main portion of the room temperature bonding apparatus and a control unit of the room temperature bonding apparatus. As shown in FIG. 1, the main portion of the room temperature bonding apparatus is provided with a load lock chamber 1, a bonding chamber 2, and a heat chamber 3. The load lock chamber 1, the bonding chamber 2 and the heat chamber 3 are containers which seal their internal spaces from environment. Moreover, the main portion of the room temperature bonding apparatus is provided with a gate valve 5 and a gate valve 6. The gate valve 5 is interposed between the load lock chamber 1 and the bonding chamber 2, and configures a first gate which connects the inner space of the bonding chamber 2 and the inner space of the load lock chamber 1. The gate valve 5 closes the first gate or opens the first gate under the control of the control unit of the bonding apparatus. The gate valve 6 is interposed between the load lock chamber 1 and the heat chamber 3 and configures a second gate which connects the inner space of the heat chamber 3 and the inner space of the load lock chamber 1. The gate valve 6 closes the second gate or opens the second gate under the control of the control unit of the bonding apparatus.

The load lock chamber 1 is provided with a lid which is not shown. The lid closes the gate which connects environment and the inner space of the load lock chamber 1 or opens the gate. The load lock chamber 1 is provided with a vacuum pump which is not shown. The vacuum pump is controlled by the control unit of the bonding apparatus when the lid, the gate valve 5 and the gate valve 6 are closed, to exhaust gas from the inner space of the load lock chamber 1. As the vacuum pump, a turbo-molecular pump, a cryopump, an oil diffusion pump is exemplified.

Moreover, the load lock chamber 1 is provided with a plurality of shelves 7 and a conveyance robot 8 in its inner space. A plurality of cartridges are put on the plurality of shelves 7. When the gate valve 5 is open, the conveyance robot 8 is controlled by the control unit of the bonding apparatus, to convey the cartridge arranged in the plurality of shelves 7 to the bonding chamber 2, or to convey the cartridge arranged in the bonding chamber 2 to the plurality of shelves 7. Moreover, when the gate valve 6 is open, the conveyance robot 8 is controlled by the control unit of the bonding apparatus, to convey the cartridge arranged in the plurality of shelves 7 to the heat chamber 3 or to convey the cartridge arranged in the heat chamber 3 to the plurality of shelves 7.

The bonding chamber 2 is provided with a vacuum pump 10. When the gate valve 5 is closed, the vacuum pump 10 is controlled by the control unit of the bonding apparatus to exhaust gas from the inner space of the bonding chamber 2. As the vacuum pump 10, a turbo-molecular pump, a cryopump, and an oil diffusion pump are exemplified.

The heat chamber 3 is provided with the vacuum pump which is not shown. When the gate valve 6 is closed, the vacuum pump is controlled by the control unit of the bonding apparatus to exhaust gas from the inner space of the heat chamber 3. As the vacuum pump, a turbo-molecular pump, a cryopump, and an oil diffusion pump are exemplified.

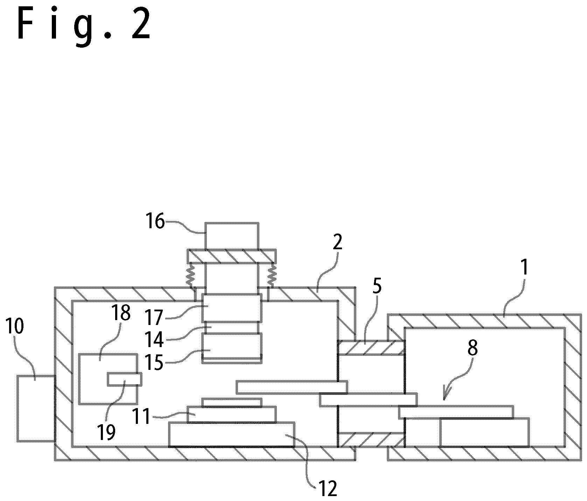

As shown in FIG. 2, the bonding chamber 2 is further provided with a positioning stage carriage 11 and a position adjusting mechanism 12. The positioning stage carriage 11 is formed in a plate manner. The positioning stage carriage 11 is arranged in the inner space of the bonding chamber 2 and is supported to be rotatable around a rotation axis parallel to a vertical direction and to be movable in parallel to a horizontal direction. The positioning stage carriage 11 is used to hold a cartridge. The position adjusting mechanism 12 is controlled by the control unit of the bonding apparatus to move the positioning stage carriage 11 in such a manner that the positioning stage carriage 11 moves in the horizontal direction or the positioning stage carriage 11 rotates around the rotation axis parallel to the vertical direction.

Moreover, the bonding chamber 2 is provided with a pressure welding axis 14, an electrostatic chuck 15, a pressure welding mechanism 16 and load meters 17. The pressure welding axis 14 is supported to be movable in parallel to the vertical direction to the bonding chamber 2. The electrostatic chuck 15 is arranged in the bottom of the pressure welding axis 14. The electrostatic chuck 15 is formed from a dielectric layer in which an inner electrode is arranged. The dielectric layer is formed of alumina-based ceramic and a flat surface is formed in the bottom. The electrostatic chuck 15 is controlled by the control unit of the bonding apparatus, and is applied with a predetermined voltage to the inner electrode. The electrostatic chuck 15 holds the wafer arranged in the neighborhood of the flat surface of the dielectric layer by the electrostatic force when the predetermined voltage is applied to the inner electrode. The pressure welding mechanism 16 is controlled by the control unit of the bonding apparatus to move the pressure welding axis 14 in parallel to the vertical direction to the bonding chamber 2. Moreover, the pressure welding mechanism 16 measures a position of the electrostatic chuck 15 and outputs the measured position to the control unit of the bonding apparatus. The load meter 17 measures a load which is applied to the wafer held by electrostatic chuck 15 by measuring the load applied to the pressure welding axis 14, and outputs the measured load to the control unit of the bonding apparatus.

Moreover, the bonding chamber 2 is provided with an ion gun 18 and an electron source 19. The ion gun 18 is controlled by the control unit of the bonding apparatus to emit the accelerated argon ions. The ion gun 18 is fixed on the bonding chamber 2 in such a manner that the argon ions are emitted in the space between the positioning stage carriage 11 and the electrostatic chuck 15, that is, the argon ions are irradiated to the wafer held by the positioning stage carriage 11 and the wafer held by the electrostatic chuck 15. The electron source 19 is controlled by the control unit of the bonding apparatus to emit accelerated electrons. The electron source 19 is fixed on the bonding chamber 2 in such a manner that the electrons are emitted in the space between the position adjusting mechanism 12 and the electrostatic chuck 15, that is, the electrons are irradiated to the wafer held by the positioning stage carriage 11 and the wafer held by the electrostatic chuck 15.

Moreover, the ion gun 18 is provided with a metal target which is not shown. The metal target is formed of a plurality of metals and is arranged in the position where the argon ions are irradiated. The metal target emits the atoms of the plurality of metals to the inner space of the bonding chamber 2 when the argon ions are irradiated. It should be noted that a metal grid may be used in substitution for the metal target. The metal grid is a metal member which has openings and is arranged at an outgoing radiation end of the ion gun 18. The metal grid emits the atoms of the plurality of metals into the inner space of the bonding chamber 2 by the irradiated argon ions, like the metal target. It should be noted that the metal target may be omitted when it is not necessary to adhere the metal atoms to the bonding planes of the wafers.

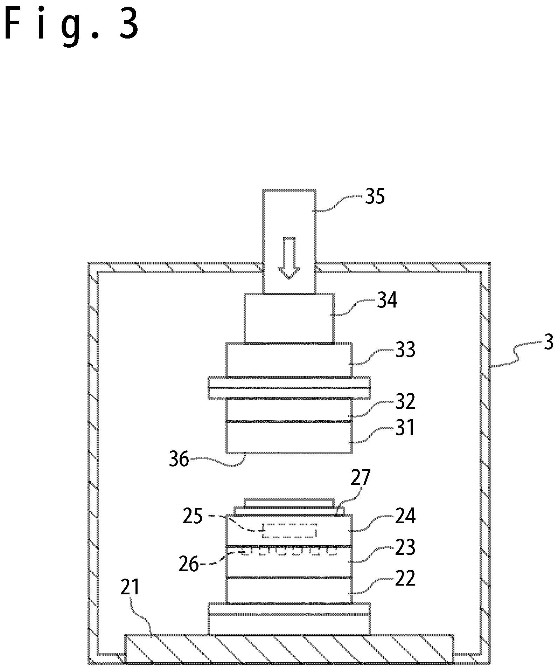

FIG. 3 shows the heat chamber 3. The heat chamber 3 is provided with a chamber base 21, a heat sink 22, an adiabatic member 23, a sample stand 24 and a heater 25. The chamber base 21 is a basis to form a part of the heat chamber 3 and to support the heat sink 22, the adiabatic member 23, the sample stand 24 and the heater 25. The heat sink 22 is fixed on the chamber base 21. The adiabatic member 23 is formed of quartz and is fixed on the chamber base 21 through the heat sink 22. It should be noted that the adiabatic member 23 can be formed from another thermal protection system with a high thermal shock which is different from quartz. As the thermal protection system, quartz glass is exemplified. The adiabatic member 23 is provided with passages 26. The passage 26 configures a conduit line through which nitrogen gas flows. The nitrogen gas is supplied from outside the heat chamber 3 by the cooling unit which is not shown. The sample stand 24 is formed of aluminum nitride AlN and is fixed on the chamber base 21 through the adiabatic member 23. It should be noted that the sample stand 24 can be formed of other materials different from aluminum nitride AlN and having an excellent heat transfer rate. As the material, carbonization silicon SiC is exemplified. In the sample stand 24, a holding surface 27 is formed on the side opposite to the side which is connected to the adiabatic member 23. The holding surface 27 is formed in such a manner that the cartridge is held by the sample stand 24. A heater 25 is arranged in the sample stand 24. The heater 25 is controlled by the control unit of the room temperature bonding apparatus to generate heat and to heat the wafer put on the cartridge. At this time, the cooled coolant is always supplied from the outside of the heat chamber 3 and prevents that the heat chamber 3 is heated when the heater 25 is turned on.

Moreover, the heat chamber 3 is provided with a substrate hold element 31, a heat sink 32, an angle adjusting mechanism 33, a load cell 34 and a pressurizing mechanism 35. The substrate hold element 31 is formed of quartz. A holding surface 36 is formed on the side of the substrate hold element 31 opposite to the sample stand 24. The holding surface 36 is formed flatly. The substrate hold element 31 is connected to the heat sink 32 on the side opposite to the side on which the holding surface 36 is formed. The heat sink 32 is connected to the angle adjusting mechanism 33 on the side opposite to the side which is connected to the substrate hold element 31. The angle adjusting mechanism 33 is connected to the load cell 34. The load cell 34 is supported to be moveable into the perpendicular direction to the upper surface of the chamber base 21. At this time, the cooled coolant is always supplied from the outside of the heat chamber 3 to the heat sink 32 and prevents that the angle adjusting mechanism 33 and the load cell 34 are heated when the substrate hold element 31 is heated.

The pressurization mechanism 35 is controlled by the control unit of the room temperature bonding apparatus to move the angle adjusting mechanism 33 into the perpendicular direction to the upper surface of the chamber base 21, that is, to move the substrate hold element 31 in the perpendicular direction to the upper surface of the chamber base 21. The load cell 34 is provided with a piezoelectric element, and measures the load applied to the holding surface 36 and a bias of the load applied to the substrate hold element 31. The load cell 34 outputs the load and the bias to the control unit of the room temperature bonding apparatus. The angle adjusting mechanism 33 is controlled by the control unit of the room temperature bonding apparatus to change the orientation of the holding surface 36.

In the load cell 34, when the piezoelectric element is heated, an error of a measurement value sometimes becomes large. The load cell 34 can measure the load and the bias in high accuracy by preventing the heat by the heat sink 32.

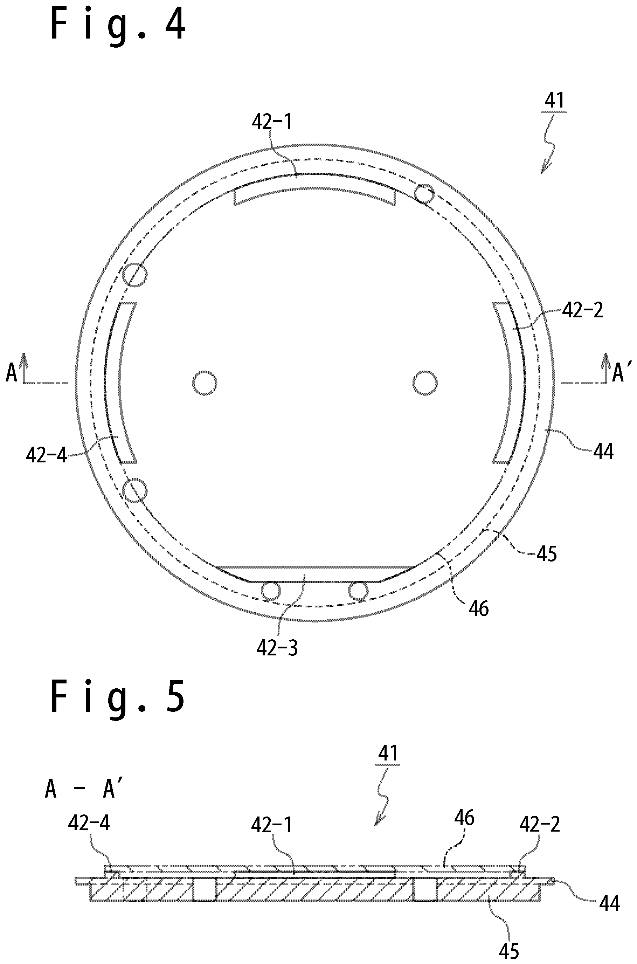

The plurality of cartridges put on the plurality of shelves 7 contains an upper cartridge and a lower cartridge. FIG. 4 shows an upper cartridge. The upper cartridge 41 is formed of aluminum, stainless steel or aluminum nitride, and is formed to have a disk-like shape. In the upper cartridge 41, a plurality of islands 42-1 to 42-4 are formed on the upper surface of the disk. The plurality of islands 42-1 to 42-4 are formed as prominences which protrude from the upper surface of the disk such that the upper ends of the prominences are on one plane.

As shown in FIG. 5, the upper cartridge 41 has a flange 44 and a main portion 45. The main portion 45 is formed like a circular column. The flange 44 is formed to extend from the side of the circular column of the main portion 45 and to have a disk shape. That is, the upper cartridge 41 is held by the conveyance robot 8 by scooping the flange 44.

The upper cartridge 41 is used by putting an upper wafer 46 on the plurality of islands 42-1 to 42-4. That is, the plurality of islands 42-1 to 42-4 are formed along the periphery of the upper wafer 46. The upper cartridge 41 is formed such that the lower surface of the upper wafer 46 touches the upper cartridge 41 in as a less area as possible, or the lower surface of the upper wafer 46 is not polluted by the upper cartridge 41, when the upper wafer 46 is put on the plurality of islands 42-1 to 42-4. The plurality of islands 42-1 to 42-4 are formed in such a manner that at least one passage is formed in the space between the upper cartridge 41 and the upper wafer 46 so as to be connected with the outside, when the upper wafer 46 is put on the plurality of islands 42-1 to 42-4. That is, the plurality of islands 42-1 to 42-4 are formed so as not to connect to each other.

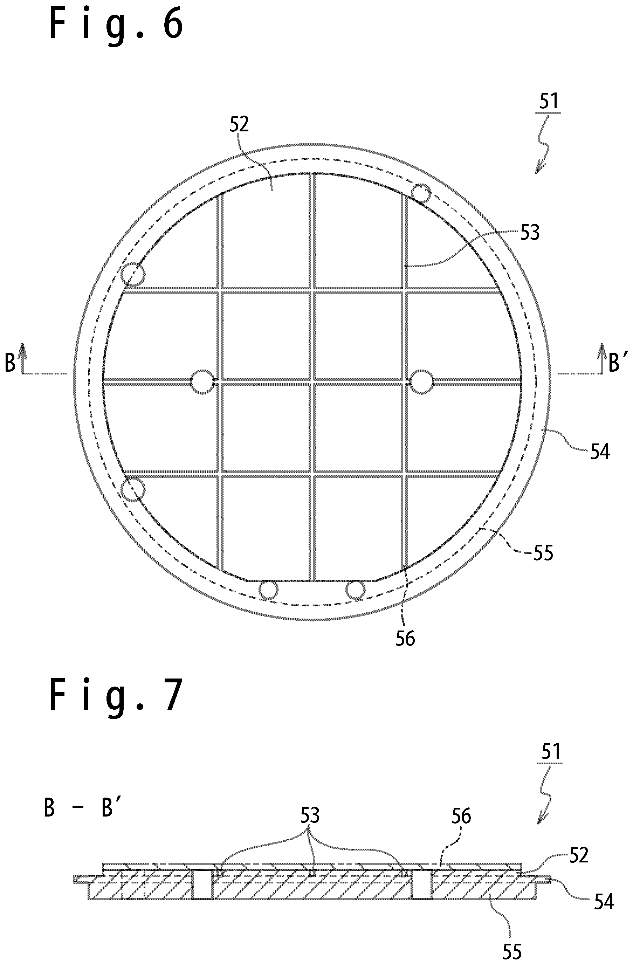

FIG. 6 shows a lower cartridge 51. The lower cartridge 51 is formed of aluminum, stainless steel or aluminum nitride, is formed to have a disk-like shape and is used to put a lower wafer. Moreover, islands 52 are formed in the upper surface of the disk on the lower cartridge 51. The islands 52 are formed as prominences which protrude from the upper surface of the disk, and are formed to have the almost same shape as the lower wafer put on the lower cartridge 51. The upper ends of the prominences are in a same plane. Ditches 53 are provided for the upper portion of the islands 52. The ditches 53 are formed in a grid shape between the islands. Moreover, the ditches 53 are formed to be connected with the sides of the islands 52.

The lower cartridge 51 is formed to have a flange 54 and a main portion 55, as shown in FIG. 7. The main portion 55 is formed to have a circular column shape. The flange 54 is formed to extend from the side of the circular column of the main portion 55 and is formed to have a disk shape. That is, the lower cartridge 51 is held by the conveyance robot 8 by scooping the flange 54.

The lower cartridge 51 is used by putting the lower wafer 56 on the islands 52. That is, the islands 52 are formed along the periphery of the lower wafer 56. Moreover, the island s52 are formed in the lower cartridge 51 in such a manner that any passage extending to the outside is formed in the space between the lower cartridge 51 and the lower wafer 56 when the lower wafer 56 is put on the islands 52. That is, the islands 52 are formed so as not to connect to each other.

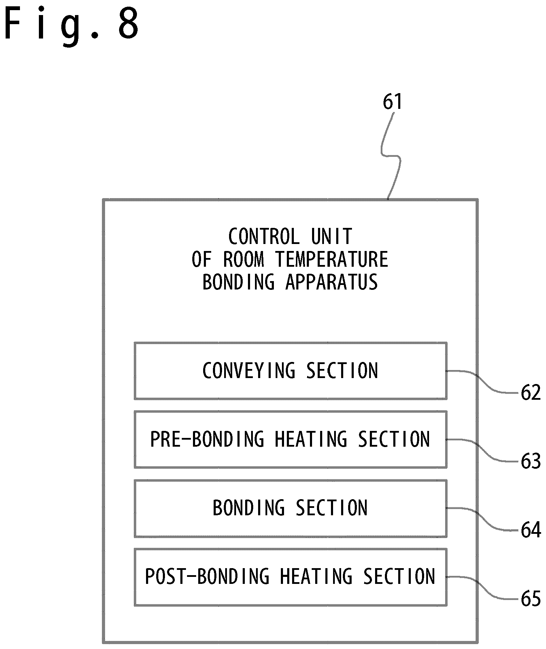

FIG. 8 shows the control unit 61 of the room temperature bonding apparatus. The control unit 61 of the room temperature bonding apparatus is a computer and is provided with a CPU, a storage, a removable memory drive, a communication unit, an input unit, an output unit and an interface, which are not shown. The CPU executes a computer program which is installed in the control unit 61 of the room temperature bonding apparatus, and controls the storage, the removable memory drive, the communication unit, the input unit, the output unit and the interface. The storage stores the computer program. Moreover, the storage stores data which are used by the CPU. The removable memory drive is used to install the computer program in the control unit 61 of the room temperature bonding apparatus when a storage medium in which the computer program is recorded is inserted. The communication unit is used to download the computer program in the control unit 61 of the room temperature bonding apparatus from another computer which is connected with the control unit 61 of the room temperature bonding apparatus through a communication network and installs the computer program in the control unit 61 of the room temperature bonding apparatus. The input unit outputs data generated by a user to the CPU. As the input unit, a keyboard and a mouse are exemplified. The output unit outputs data generated by the CPU in the form with which it is possible to be recognized by the user. As the output unit, a display which displays images generated by the CPU is exemplified.

The interface outputs the data generated by the CPU to an external unit connected with the control unit 61 of the room temperature bonding apparatus and the data generated by the external unit to the CPU. The external unit is provided with the gate valve 5, the gate valve 6, the conveyance robot 8, the vacuum pump which exhausts from the load lock chamber 1, the vacuum pump which exhausts from the heat chamber 3, the vacuum pump 10, the position adjusting mechanism 12, the electrostatic chuck 15, the pressure welding mechanism 16, the load meter 17, the ion gun 18, the electron source 19, the heater 25, the cooling unit which supplies the coolant to the passages 26, the heater 25, the angle adjusting mechanism 33, the load cell 34, and the pressurization mechanism 35.

The computer program is installed in the control unit 61 of the room temperature bonding apparatus and is formed from a plurality of computer programs for the control unit 61 of the room temperature bonding apparatus to realize a plurality of functions. The plurality of functions contain a conveying section 62, a pre-heating section 63, a bonding section 64 and a post-heating section 65.

When the gate valve 5 and the gate valve 6 are closed, the conveying section 62 controls the vacuum pump of the load lock chamber 1 such that a preliminary atmosphere of a given degree of vacuum is generated in the inner space of the load lock chamber 1 or an atmospheric pressure atmosphere is generated in the inner space of the load lock chamber 1. When the preliminary atmosphere is generated in the inner space of the load lock chamber 1, the conveying section 62 controls the gate valve 5 to be opened and closed and the gate valve 6 to be opened and closed.

When the gate valve 5 is opened, the conveying section 62 controls the conveyance robot 8 such that the upper cartridge 41 or lower cartridge 51 arranged in the plurality of shelves 7 is conveyed to the positioning stage carriage 11 in the bonding chamber 2, or the upper cartridge 41 or lower cartridge 51 held by the positioning stage carriage 11 is conveyed to the plurality of shelves 7 in the load lock chamber 1. When the gate valve 6 is opened, the conveying section 62 controls the conveyance robot 8 such that the upper cartridge 41 or lower cartridge 51 arranged in the plurality of shelves 7 is conveyed to the sample stand 24 in the heat chamber 3 or the upper cartridge 41 or lower cartridge 51 held by the sample stand 24 of the heat chamber 3 is conveyed to the plurality of shelves 7 in the load lock chamber 1.

When the gate valve 6 is closed, the pre-bonding heating section 63 controls the vacuum pump of the heat chamber 3 such that a desorption atmosphere of a given degree of vacuum is generated in the inner space of the heat chamber 3. When the desorption atmosphere is generated in the inner space of the heat chamber 3 and the upper cartridge 41 is held by the sample stand 24 in the heat chamber 3, the pre-bonding heating section 63 controls the heater 25 such that the upper wafer 46 put on the upper cartridge 41 is heated to a predetermined desorption temperature, that is, desorption of absorption material is carried out from the upper wafer 46. The absorption material is material which is adhered to the upper wafer 46 and water and atmosphere components are exemplified. As the desorption temperature, 200 °C is exemplified. The pre-bonding heating section 63 controls the heater 25 such that the upper wafer 46 is not heated after the upper wafer 46 is heated for a predetermined time period, that is, after desorption of the absorption materials are sufficiently carried out from the upper wafer 46, and controls a cooling unit of the heat chamber 3 such that nitrogen gas flows through the passages 26, that is, the upper wafer 46 is cooled to the bonding temperature. The bonding temperature is set to be contained in a temperature range in which a product produced from the upper wafer 46 is used.

When the desorption atmosphere is generated in the inner space of the heat chamber 3 and the lower cartridge 51 is held by the sample stand 24 in the heat chamber 3, the pre-bonding heating section 63 controls the heater 25 in such a manner that the lower wafer 56 put on the lower cartridge 51 is heated at a predetermined desorption temperature, that is, desorption of the absorption material is carried out from the lower wafer 56. After the lower wafer 56 is heated for a predetermined time period, that is, after desorption of the absorption material is sufficiently carried out from the lower wafer 56, the pre-bonding heating section 63 controls the heater 25 not to heat the lower wafer 56, and controls a cooling unit of the heat chamber 3 such that the nitrogen gas flows through the passages 26, that is, the lower wafer 56 is cooled to the bonding temperature.

When the upper cartridge 41 is put on the positioning stage carriage 11, the bonding section 64 controls the pressure welding mechanism 16 such that the electrostatic chuck 15 falls down. When the electrostatic chuck 15 falls down, the bonding section 64 controls the load meter 17 to measure the load applied to the electrostatic chuck 15. The bonding section 64 calculates based on the load, a timing at which the load reaches a given contact load, namely, calculates the timing at which the upper wafer 46 on the upper cartridge 41 touches the electrostatic chuck 15. The bonding section 64 controls the pressure welding mechanism 16 to stop the electrostatic chuck 15 at the timing. The bonding section 64 controls the electrostatic chuck 15 such that the electrostatic chuck 15 holds the upper wafer 46 when the upper wafer 46 on the upper cartridge 41 is in contact with the electrostatic chuck 15. The bonding section 64 controls the pressure welding mechanism 16 to raise the electrostatic chuck 15 when the electrostatic chuck 15 holds the upper wafer 46 on the upper cartridge 41.

The bonding section 64 controls the vacuum pump 10 such that a bonding atmosphere of a given degree of vacuum is generated in the inner space of the bonding chamber 2 when the gate valve 5 is closed. Moreover, when the bonding atmosphere is generated in the inner space of the bonding chamber 2, the bonding section 64 controls the ion gun 18 such that the argon ions are irradiated to the upper wafer 46 and the lower wafer 56. Moreover, the bonding section 64 controls the electron source 19 such that electrons are emitted while the argon ions are emitted.

Moreover, when the electrostatic chuck 15 holds the upper wafer 46 and the lower cartridge 51 is put on the positioning stage carriage 11, the bonding section 64 controls the pressure welding mechanism 16 such that the lower wafer 56 and upper wafer 46 on the lower cartridge 51 approach to each other to a given adjustment distance. Moreover, when the upper wafer 46 is apart from the lower wafer 56 by an adjustment distance, the bonding section 64 controls the position adjusting mechanism 12 such that the lower wafer 56 is arranged in the adjustment position from the upper wafer 46. An adjustment position is set such that the upper wafer 46 and the lower wafer 56 are bonded as designed when the electrostatic chuck 15 falls down.

Moreover, the bonding section 64 controls the pressure welding mechanism 16 for the electrostatic chuck 15 to descend when the lower wafer 56 is arranged in the adjustment position. The bonding section 64 controls the load meter 17 to measure the load applied to the electrostatic chuck 15 when the electrostatic chuck 15 falls down. The bonding section 64 calculates the timing when the load reaches a given bonding load. The bonding section 64 controls the pressure welding mechanism 16 such that the electrostatic chuck 15 stops at the calculated timing, that is, the bonding load is applied to the upper wafer 46 and the lower wafer 56.

After the bonding load is applied to the upper wafer 46 and the lower wafer 56 for the given bonding time period, the bonding section 64 controls the electrostatic chuck 15 such that a bonding resultant wafer produced from the upper wafer 46 and the lower wafer 56 leave the electrostatic chuck 15. The bonding section 64 controls the pressure welding mechanism 16 to raise the electrostatic chuck 15 after the bonded wafer leaves the electrostatic chuck 15.

When the lower cartridge 51 is held by the sample stand 24 in the heat chamber 3, the post-bonding heating section 65 controls the pressurization mechanism 35 to fall down the substrate hold element 31. When the substrate hold element 31 falls down, the post-bonding heating section 65 controls the load cell 34 to measure the load applied to the substrate hold element 31, and to measure the bias of the load applied to the substrate hold element 31. The post-bonding heating section 65 controls the pressurization mechanism 35 such that a given hold load is applied to the bonding resultant wafer. The post-bonding heating section 65 controls the angle adjusting mechanism 33 based on the bias such that the holding surface 36 of the substrate hold element 31 becomes parallel to the upper surface of the bonding resultant wafer, that is, the hold load is uniformly applied to the bonding wear.

When the given hold load is applied to the bonding resultant wafer, the post-bonding heating section 65 controls the heater 25 such that the bonding resultant wafer is heated at a predetermined annealing temperature, that is, the bonding resultant wafer is subjected to an annealing. As the annealing temperature, 480 °C is exemplified. The post-bonding heating section 65 controls the heater 25 such that the lower cartridge 51 is not heated after the bonding resultant wafer is heated for a predetermined time period, that is, after the bonding resultant wafer is annealed, and controls the cooling unit of the heat chamber 3 such that the nitrogen gas flows through the passages 26, that is, the lower cartridge 51 is cooled to a transportable temperature. Moreover, the post-bonding heating section 65 controls the pressurization mechanism 35 such that the substrate hold element 31 rises after the bonding resultant wafer is annealed.

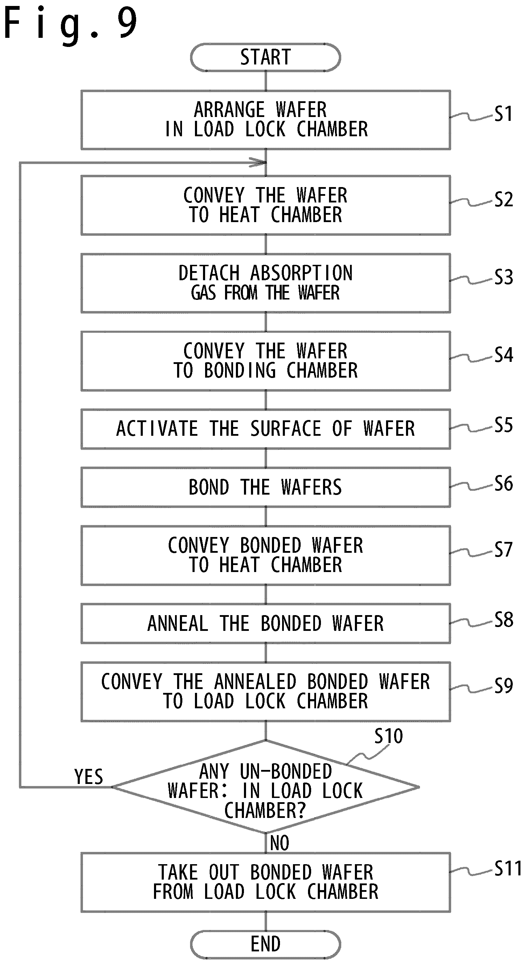

FIG. 9 shows an embodiment of the room temperature bonding method The room temperature bonding method is executed by using the room temperature bonding apparatus. The control unit 61 of the room temperature bonding apparatus controls the gate valve 5 to close the first gate which connects the inner space of the load lock chamber 1 and the inner space of the bonding chamber 2, and controls the gate valve 6 to close the second gate which connects the inner space of the load lock chamber 1 and the inner space of the heat chamber 3. When the gate valve 5 and the gate valve 6 are closed, the control unit 61 of the room temperature bonding apparatus controls the vacuum pump of the load lock chamber 1 such that an atmospheric pressure atmosphere is generated in the inner space of the load lock chamber 1, and controls the vacuum pump 10 such that a bonding atmosphere is generated in the inner space of the bonding chamber 2, and controls the vacuum pump of the heat chamber 3 such that a desorption atmosphere is generated in the inner space of the heat chamber 3.

When the atmospheric pressure atmosphere is generated in the inner space of the load lock chamber 1, the user opens the lid of the load lock chamber 1 and arranges a plurality of cartridges on the plurality of shelves 7. The plurality of cartridges contain a plurality of upper cartridges 41 and a plurality of lower cartridges 51. The upper wafers 46 are put on the upper cartridges 41. The lower wafers 56 are put on the lower cartridges 51. The user closes the lid of the load lock chamber 1 after arranging the plurality of cartridges on the plurality of shelves 7. When the lid of the load lock chamber 1 is closed, the control unit 61 of the room temperature bonding apparatus controls the vacuum pump of the load lock chamber 1 such that the preliminary atmosphere is generated in the inner space of the load lock chamber 1 (Step S1).

The control unit 61 of the room temperature bonding apparatus controls the gate valve 6 such that the gate valve 6 is opened when the preliminary atmosphere is generated in the inner space of the load lock chamber 1. When the gate valve 6 is opened, the control unit 61 of the room temperature bonding apparatus controls the conveyance robot 8 such that an upper cartridge 41 as one of the plurality of cartridges which have been arranged on the plurality of shelves 7 is conveyed on the sample stand 24 of the heat chamber 3 (Step S2).

The control unit 61 of the room temperature bonding apparatus controls the gate valve 6 to close the gate valve 6 after the upper cartridge 41 is held by the sample stand 24 of the heat chamber 3. When the gate valve 6 is closed, the control unit 61 of the room temperature bonding apparatus controls the vacuum pump of the heat chamber 3 such that the desorption atmosphere is generated in the inner space of the heat chamber 3. When the desorption atmosphere is generated in the inner space of the heat chamber 3, the control unit 61 of the room temperature bonding apparatus controls the heater 25 such that the upper wafer 46 put on the upper cartridge 41 is heated to the predetermined desorption temperature, that is, desorption of the absorption material is carried out from the upper wafer 46 (Step S3). The control unit 61 of the room temperature bonding apparatus controls the heater 25 not to heat the upper wafer 46, after the upper wafer 46 is heated for the predetermined time period, that is, after desorption of the absorption material is sufficiently carried out from the upper wafer 46, and controls the cooling unit of the heat chamber 3 such that the nitrogen gas flows through the passages 26, that is, the upper wafer 46 is cooled to the bonding temperature.

The control unit 61 of the room temperature bonding apparatus controls the gate valve 6 such that the gate valve 6 is opened after the desorption of the absorption material is sufficiently carried out from the upper wafer 46. The control unit 61 of the room temperature bonding apparatus controls the conveyance robot 8 such that the upper cartridge 41 is conveyed from the sample stand 24 of the heat chamber 3 to the plurality of shelves 7 after the upper wafer 46 is cooled to the bonding temperature.

Next, after the upper cartridge 41 is conveyed from the sample stand 24 of the heat chamber 3, the control unit 61 of the room temperature bonding apparatus controls the conveyance robot 8 such that a lower cartridge 51 as a next one of the plurality of cartridges arranged in the plurality of shelves 7 is conveyed to the sample stand 24 of the heat chamber 3 (Step S2). The control unit 61 of the room temperature bonding apparatus controls the gate valve 6 such that the gate valve 6 is closed after the lower cartridge 51 is held by the sample stand 24 of the heat chamber 3. When the gate valve 6 is in the closed state, the control unit 61 of the room temperature bonding apparatus controls the vacuum pump of the heat chamber 3 such that the desorption atmosphere is generated in the inner space of the heat chamber 3. When the desorption atmosphere is generated in the inner space of the heat chamber 3, the control unit 61 of the room temperature bonding apparatus controls the heater 25 such that the lower wafer 56 put on the lower cartridge 51 is heated at the predetermined desorption temperature, that is, desorption of absorption material is carried out from the lower wafer 56 (Step S3). After the lower wafer 56 is heated for the predetermined time period, that is, after the desorption of the absorption material is sufficiently carried out from the lower wafer 56, the control unit 61 of the room temperature bonding apparatus controls the heater 25 such that the lower wafer 56 is not heated, and controls the cooling unit of the heat chamber 3 such that nitrogen gas flows through the passages 26, that is, the lower wafer 56 is cooled to the bonding temperature.

The control unit 61 of the room temperature bonding apparatus controls the gate valve 6 such that the gate valve 6 is opened after the desorption of the absorption material is sufficiently carried out from the lower wafer 56. The control unit 61 of the room temperature bonding apparatus controls the conveyance robot 8 such that the lower cartridge 51 is conveyed from the sample stand 24 of the heat chamber 3 to the plurality of shelves 7 after the lower wafer 56 is cooled to the bonding temperature.

The control unit 61 of the room temperature bonding apparatus controls the gate valve 5 such that the gate valve 5 is opened after the desorption of the absorption material is sufficiently carried out from the upper wafer 46 and the lower wafer 56. The control unit 61 of the room temperature bonding apparatus controls the conveyance robot 8 such that the upper cartridge 41 on which the upper wafer 46 subjected to the desorption is put is conveyed from the plurality of shelves 7 to the positioning stage carriage 11 of the bonding chamber 2. Next, the control unit 61 of the room temperature bonding apparatus controls the pressure welding mechanism 16 such that the electrostatic chuck 15 falls down. The control unit 61 of the room temperature bonding apparatus controls the load meter 17 such that the load applied to the electrostatic chuck 15 is measured when the electrostatic chuck 15 falls down. The control unit 61 of the room temperature bonding apparatus calculates based on the load, a timing at which the load reaches a predetermined contact load, i.e. the timing at which the upper wafer 46 on the upper cartridge 41 touches the electrostatic chuck 15. The control unit 61 of the room temperature bonding apparatus controls the pressure welding mechanism 16 such that the electrostatic chuck 15 stops at the timing.

The control unit 61 of the room temperature bonding apparatus controls the electrostatic chuck 15 such that the electrostatic chuck 15 holds the upper wafer 46 when the electrostatic chuck 15 touches the upper wafer 46 on the upper cartridge 41. The control unit 61 of the room temperature bonding apparatus controls the pressure welding mechanism 16 such that the electrostatic chuck 15 rises when the electrostatic chuck 15 holds the upper wafer 46 on the upper cartridge 41. The control unit 61 of the room temperature bonding apparatus controls the conveyance robot 8 such that the upper cartridge 41 with no upper wafer 46 is conveyed from the positioning stage carriage 11 to the plurality of shelves 7 after the electrostatic chuck 15 rises to a given activation position.

The control unit 61 of the room temperature bonding apparatus controls the conveyance robot 8 such that the lower cartridge 51 on which the lower wafer 56 subjected to the desorption is put, from the plurality of shelves 7 to the positioning stage carriage 11 after the upper cartridge 41 has been conveyed to the plurality of shelves 7. The control unit 61 of the room temperature bonding apparatus controls the gate valve 5 such that the gate valve 5 is closed after the lower cartridge 51 is held by the positioning stage carriage 11 (Step S4).

When the gate valve 5 is closed, the control unit 61 of the room temperature bonding apparatus controls the vacuum pump 10 such that the bonding atmosphere is generated in the inner space of the bonding chamber 2. When the bonding atmosphere is generated in the inner space of the bonding chamber 2, the control unit 61 of the room temperature bonding apparatus controls the ion gun 18 such that argon ions are irradiated to the upper wafer 46 and the lower wafer 56. Moreover, the control unit 61 of the room temperature bonding apparatus controls the electron source 19 such that electrons are emitted while the argon ions are emitted (Step S5).

The control unit 61 of the room temperature bonding apparatus controls the pressure welding mechanism 16 such that the lower wafer 56 and the upper wafer 46 approach to the given adjustment distance. When the upper wafer 46 and the lower wafer 56 leave by the adjustment distance, the control unit 61 of the room temperature bonding apparatus controls the position adjusting mechanism 12 such that the lower wafer 56 is arranged in a given adjustment position to the upper wafer 46.

Moreover, the control unit 61 of the room temperature bonding apparatus controls the pressure welding mechanism 16 such that the electrostatic chuck 15 falls down after the lower wafer 56 is arranged in the adjustment position. The control unit 61 of the room temperature bonding apparatus controls the load meter 17 such that the load applied to the electrostatic chuck 15 is measured when the electrostatic chuck 15 falls down. The control unit 61 of the room temperature bonding apparatus calculates the timing at which the load reaches the predetermined bonding load. The control unit 61 of the room temperature bonding apparatus controls the pressure welding mechanism 16 such that the electrostatic chuck 15 stops at the timing, that is, the bonding load is applied to the upper wafer 46 and the lower wafer 56 (Step S6). The lower wafer 56 and the upper wafer 46 are bonded by applying the bonding load to form a bonding resultant wafer.

The control unit 61 of the room temperature bonding apparatus controls the electrostatic chuck 15 such that the bonding resultant wafer leaves the electrostatic chuck 15 after the bonding load is applied for a given bonding time period. The control unit 61 of the room temperature bonding apparatus controls the pressure welding mechanism 16 such that the electrostatic chuck 15 rises after the bonding resultant wafer leaves the electrostatic chuck 15.

The control unit 61 of the room temperature bonding apparatus controls the gate valve 5 such that the gate valve 5 is opened after the electrostatic chuck 15 rises sufficiently. When the gate valve 5 is opened, the control unit 61 of the room temperature bonding apparatus controls the conveyance robot 8 such that the lower cartridge 51 on which the bonding resultant wafer is put is conveyed from the positioning stage carriage 11 to the load lock chamber 1.

The control unit 61 of the room temperature bonding apparatus controls the gate valve 6 such that the gate valve 6 is opened when the preliminary atmosphere is generated in the inner space of the load lock chamber 1. The control unit 61 of the room temperature bonding apparatus controls the conveyance robot 8 such that the lower cartridge 51 on which the bonding resultant wafer is put is conveyed from the load lock chamber 1 to the sample stand 24 of the heat chamber 3 when the gate valve 6 is opened (Step S7).

The control unit 61 of the room temperature bonding apparatus controls the pressurization mechanism 35 such that the substrate hold element 31 falls down when the lower cartridge 51 is held on the sample stand 24 of the heat chamber 3. When the substrate hold element 31 falls down, the control unit 61 of the room temperature bonding apparatus controls the load cell 34 such that the load applied to the substrate hold element 31 is measured, and the bias of the load applied to the substrate hold element 31 is measured. The control unit 61 of the room temperature bonding apparatus controls the pressurization mechanism 35 in a predetermined sampling period such that a given pressing load is applied to the bonding resultant wafer. The control unit 61 of the room temperature bonding apparatus controls the angle adjusting mechanism 33 in the predetermined sampling period such that the holding surface 36 of the substrate hold element 31 becomes parallel to the upper surface of the bonding resultant wafer based on the bias, that is, the pressing load is uniformly applied to the bonding resultant wafer. When the pressing load is applied to the bonding resultant wafer, the control unit 61 of the room temperature bonding apparatus controls the heater 25 in the predetermined sampling period such that the bonding resultant wafer is heated at a predetermined annealing temperature, that is, the bonding resultant wafer is annealed (Step S8).

The bonding resultant wafer is heated for a predetermined annealing time period, and the residual stress is reduced. The annealing time for several minutes is exemplified. After the bonding resultant wafer is annealed, the control unit 61 of the room temperature bonding apparatus controls the heater 25 not to heat the lower cartridge 51, and controls the cooling unit of the heat chamber 3 such that nitrogen gas flows through the passages 26, that is, the lower cartridge 51 is cooled to the transportable temperature. As the transportable temperature, the room temperature is exemplified. After the bonding resultant wafer is annealed, the control unit 61 of the room temperature bonding apparatus controls the pressurization mechanism 35 to raise the substrate hold element 31. After the substrate hold element 31 rises sufficiently, the control unit 61 of the room temperature bonding apparatus controls the conveyance robot 8 such that the lower cartridge 51 on which the annealed bonding resultant wafer is put is conveyed from the positioning stage carriage 11 to the plurality of shelves 7 (Step S9).

When the upper cartridge 41 on which the upper wafer 46 is put and the lower cartridge 51 on which the lower wafer 56 is put are arranged in the plurality of shelves 7 (Step S10, YES), the control unit 61 of the room temperature bonding apparatus executes the operation of the steps S2 to S9 repeatedly again.

When the wafer to be bonded is not arranged in the plurality of shelves 7 (Step S10, NO), the control unit 61 of the room temperature bonding apparatus controls the gate valve 5 such that the gate valve 5 is closed, and controls the gate valve 6 such that the gate valve 6 is closed. The control unit 61 of the room temperature bonding apparatus controls the vacuum pump of the load lock chamber 1 such that an atmospheric pressure atmosphere is generated in the inner space of the load lock chamber 1 after the gate valve 5 and the gate valve 6 are closed. The user opens the lid of the load lock chamber 1 after the atmospheric pressure atmosphere is generated in the inner space of the load lock chamber 1 and takes out the plurality of cartridges from the plurality of shelves 7. The plurality of cartridges contain the plurality of upper cartridges 41 and the plurality of lower cartridges 51. The bonding resultant wafer is put on the lower cartridge 51.

Moreover, when the upper wafer 46 and the lower wafer 56 should be bonded at the room temperature, the user executes the above room temperature bonding method once again after arranging the upper cartridge 41 on which the upper wafer 46 is put and the lower cartridge 51 on which the lower wafer 56 are put in the plurality of shelves 7.

The contact area in the room temperature bonding becomes small when the warpage is large in the lower wafer 56 and the upper wafer 46, and there is a case that enough bonding strength is not obtained. When the upper wafer 46 and the lower wafer 56 are bonded while a sufficiently large load is applied, these wafers are bonded in the enough bonding strength even when the warpage is large. When the upper wafer 46 and the lower wafer 56 should be bonded while the sufficiently large load is applied, the residual stress sometimes occurs even when the warpage is large. Such a residual stress sometimes affects a product which is made from the upper wafer 46 and the lower wafer 56. As an adverse influence, a flaw, and a malfunction on the function are exemplified.

According to such a room temperature bonding method, the residual stress can be reduced even if the residual stress occurs in the bonding resultant wafer when the upper wafer 46 and the lower wafer 56 have been bonded, and the products with good quality can be made stably.

In the bonding resultant wafer in which two wafers with absorption materials are bonded at the room temperature, voids are generated due to the absorption material in the bonding plane through the annealing and the bonding strength is sometimes reduced. In such a room temperature bonding method, the absorption material remaining in the bonding plane of the bonding resultant wafer can be reduced through the operation (steps S2-S3) of carrying out desorption of the absorption material from the upper wafer 46 and the lower wafer 56. As a result, the void generation in the bonding plane can be prevented and the bonding strength can be improved.

It should be noted that in the room temperature bonding method the operation (steps S2 and S3) of carrying out the desorption of the absorption material from the upper wafer 46 and the lower wafer 56 can be omitted, when the absorption material absorbed to the upper wafer 46 and the lower wafer 56 is sufficiently little. Even by such a room temperature bonding method, the product with good quality can be made stably, like the room temperature bonding method according to the previously embodiment.

It is sometimes required that the product which is produced from the bonding resultant wafer has a predetermined shape. Even when the warpage of the bonding resultant wafer before the annealing is large, the bonding resultant wafer can be formed flatly by annealing while the pressing load is applied, and can be applied to such a product.

It should be noted that in the room temperature bonding method when the bonding resultant wafer before the annealing is enough flat, that is, the room temperature bonding is possible to be carried out such that the bonding resultant wafer is flat sufficiently, it is possible to omit the application of the pressing load in the annealing. Such a room temperature bonding method can stably produce the product with good quality, like the room temperature bonding method according to the previous embodiments.

The load applied to the bonding resultant wafer sometimes increases, because the bonding resultant wafer and a unit which treats the bonding resultant wafer thermally expands while the bonding resultant wafer is subjected to the annealing. The bonding resultant wafer sometimes breaks when the applied load is large sufficiently. According to the room temperature bonding method, because the load applied to the bonding resultant wafer is controlled to a pressing load, it is possible to prevent the bonding resultant wafer from breaking and the product with good quality can be produced stably. It should be noted that in the room temperature bonding method when a unit which treats the bonding resultant wafer deforms elastically so that the load applied to the bonding resultant wafer does not become larger than the predetermined load, a feeding-back operation can be omitted in which the load applied to the bonding resultant wafer is controlled to the pressing load after controlling to the pressing load once.

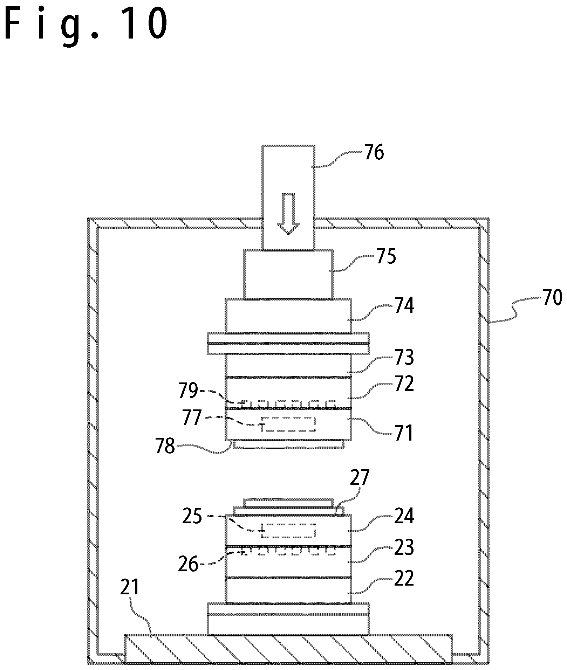

In another embodiment of the room temperature bonding apparatus another heat chamber is substituted for the heat chamber 3 in the previous embodiments. The heat chamber 70 is provided with the chamber base 21, the heat sink 22, the adiabatic member 23, the sample stand 24 and the heater 25 as shown in FIG. 10, like the heat chamber 3 in the above embodiments.

Also, the heat chamber 70 is further provided with an electrostatic chuck 71, an adiabatic member 72, a heat sink 73, an angle adjusting mechanism 74, a load cell 75, a pressurization mechanism 76 and a heater 77. In the electrostatic chuck 71, the holding surface 78 is formed on the side opposing to the sample stand 24. The holding surface 78 is formed to be flat. In the electrostatic chuck 71, the adiabatic member 72 is formed on the side opposite to the side on which the holding surface 78. The electrostatic chuck 71 is controlled by the control unit 61 of the room temperature bonding apparatus, to hold the wafer arranged in the neighborhood on the holding surface 78 with electrostatic force. The adiabatic member 72 is formed of quartz and is connected to the heat sink 73. The adiabatic member 72 is provided with passages 79. The passages 79 form conduit lines through which nitrogen gas flows. The nitrogen gas is supplied from the outside of the heat chamber 70 by a cooling unit which is not shown. The side of the heat sink 73 opposite to the side on which is connected to the electrostatic chuck 71, is connected to the angle adjusting mechanism 74. The angle adjusting mechanism 74 is connected to the load cell 75. The load cell 75 is supported to be moveable into a perpendicular direction to the surface of the chamber base 21. At this time, cooled coolant is always supplied from outside the heat chamber 70 so that the heat sink 73 prevents that the angle adjusting mechanism 74 and the load cell 75 are heated when the electrostatic chuck 71 is heated.

The pressurization mechanism 76 is controlled by the control unit of the room temperature bonding apparatus, to move the angle adjusting mechanism 74 into the perpendicular direction to the top surface of the chamber base 21, that is, to move the electrostatic chuck 71 into the perpendicular direction to the top surface of the chamber base 21. The load cell 75 is provided with a piezoelectric element, measures the load applied to the holding surface 78 and measures the bias of the load applied to the electrostatic chuck 71. The load cell 75 outputs the load and the bias to the control unit of the room temperature bonding apparatus. The angle adjusting mechanism 74 is controlled by the control unit of the room temperature bonding apparatus, to change the orientation of the holding surface 78.

When the piezoelectric element of the load cell 75 is heated, an error of the measured value sometimes becomes large. The load cell 75 can measure the load and the bias in higher accuracy by preventing from heating by the heat sink 73.

The heater 77 is arranged in the inner space of the electrostatic chuck 71. The heater 77 is controlled by the control unit 61 of the room temperature bonding apparatus, to heat the wafer held by the electrostatic chuck 71. At this time, the cooled coolant is always supplied from outside the heat chamber 70 to the heat sink 73, to prevent that the load cell 75 is heated when the heater 77 is heated.

Another embodiment of the room temperature bonding method is executed by using a main portion of the room temperature bonding apparatus to which the heat chamber 70 is applied, to substitute another operation for steps S2 and S3 in the previous embodiments. In the operation, the control unit 61 of the room temperature bonding apparatus controls the gate valve 6 such that the gate valve 6 is opened when the preliminary atmosphere is generated in the inner space of the load lock chamber 1. When the gate valve 6 is opened, the control unit 61 of the room temperature bonding apparatus controls the conveyance robot 8 such that the upper cartridge 41 of the plurality of cartridges which are arranged in the plurality of shelves 7 is conveyed to the sample stand 24 of the heat chamber 70.

The control unit 61 of the room temperature bonding apparatus controls the pressurization mechanism 76 such that the electrostatic chuck 71 falls down after the upper cartridge 41 is held on the sample stand 24 of the heat chamber 70. The control unit 61 of the room temperature bonding apparatus controls the load cell 75 such that the load applied to the electrostatic chuck 71 is measured, when the electrostatic chuck 71 falls down. The control unit 61 of the room temperature bonding apparatus calculates based on the load, the timing when the load reaches a given contact load, that is, the timing at which the upper wafer 46 on the upper cartridge 41 touches the electrostatic chuck 71. The control unit 61 of the room temperature bonding apparatus controls the pressurization mechanism 76 to stop the electrostatic chuck 71 at the timing.

When the electrostatic chuck 71 touches the upper wafer 46 on the upper cartridge 41, the control unit 61 of the room temperature bonding apparatus controls the electrostatic chuck 71 such that the electrostatic chuck 71 holds the upper wafer 46. The control unit 61 of the room temperature bonding apparatus controls the pressurization mechanism 76 such that the electrostatic chuck 71 rises when the electrostatic chuck 71 holds the upper wafer 46 on the upper cartridge 41. The control unit 61 of the room temperature bonding apparatus controls the conveyance robot 8 such that the upper cartridge 41 is conveyed from the sample stand 24 to the plurality of shelves 7 on which the upper wafer 46 is not present after the electrostatic chuck 71 rises to a predetermined position.

After the upper cartridge 41 is conveyed to the plurality of shelves 7, the control unit 61 of the room temperature bonding apparatus controls the conveyance robot 8 such that the lower cartridge 51 on which the lower wafer 56 is put is conveyed from the plurality of shelves 7 to the sample stand 24. The control unit 61 of the room temperature bonding apparatus controls the gate valve 6 such that the gate valve 6 is closed after the lower cartridge 51 is held on the sample stand 24.

The control unit 61 of the room temperature bonding apparatus controls the vacuum pump of the heat chamber 70 such that the desorption atmosphere is generated in the inner space of the heat chamber 70 when the gate valve 6 is in the closed state. When the desorption atmosphere is generated in the inner space of the heat chamber 70, the control unit 61 of the room temperature bonding apparatus controls the heater 77 such that the upper wafer 46 held by the electrostatic chuck 71 is heated at a predetermined desorption temperature, and controls the heater 25 such that the lower wafer 56 put on the lower cartridge 51 is heated at the desorption temperature.

The control unit 61 of the room temperature bonding apparatus controls the heater 77 such that the upper wafer 46 is not heated after the upper wafer 46 is heated for a predetermined time period, controls the cooling unit of the heat chamber 70 such that nitrogen gas flows through the passages 79, that is, the upper wafer 46 is cooled to the bonding temperature. The control unit 61 of the room temperature bonding apparatus controls the heater 25 such that the lower wafer 56 is not heated after the lower wafer 56 is heated for a predetermined time period, and controls the cooling unit of the heat chamber 70 such that nitrogen gas flows through the passages 26, that is, the lower wafer 56 is cooled to the bonding temperature.

The control unit 61 of the room temperature bonding apparatus controls the gate valve 6 such that the gate valve 6 is opened after desorption of the absorption material is sufficiently carried out from the upper wafer 46 and the lower wafer 56. The control unit 61 of the room temperature bonding apparatus controls the conveyance robot 8 such that the lower cartridge 51 is conveyed from the sample stand 24 of the heat chamber 70 to the plurality of shelves 7 after the lower wafer 56 is cooled to the bonding temperature.

After the lower cartridge 51 is conveyed from the sample stand 24 of the heat chamber 70, the control unit 61 of the room temperature bonding apparatus controls the conveyance robot 8 such that the upper cartridge 41 on which any wafer is not put is conveyed to the sample stand 24 of the heat chamber 70. The control unit 61 of the room temperature bonding apparatus controls the pressurization mechanism 76 such that the electrostatic chuck 71 falls down after the upper cartridge 41 is held by the sample stand 24 of the heat chamber 70. The control unit 61 of the room temperature bonding apparatus controls the load cell 75 such that the load applied to the electrostatic chuck 71 is measured when the electrostatic chuck 71 falls down. The control unit 61 of the room temperature bonding apparatus calculates based on the load, the timing at which the load reaches the given contact load, that is, the timing at which the upper wafer 46 held by the electrostatic chuck 71 touches the upper cartridge 41. The control unit 61 of the room temperature bonding apparatus controls the pressurization mechanism 76 such that the electrostatic chuck 71 stops at the timing.

When the electrostatic chuck 71 touches the upper wafer 46 on the upper cartridge 41, the control unit 61 of the room temperature bonding apparatus controls the electrostatic chuck 71 such that the upper wafer 46 leave the electrostatic chuck 71. The control unit 61 of the room temperature bonding apparatus controls the pressurization mechanism 76 such that the electrostatic chuck 71 rise after the upper wafer 46 leaves the electrostatic chuck 71. After the electrostatic chuck 71 rises to a predetermined position, the control unit 61 of the room temperature bonding apparatus controls the conveyance robot 8 such that the upper cartridge 41 on which the upper wafer 46 is put is conveyed from the sample stand 24 to the plurality of shelves 7.

The room temperature bonding method to which such an operation is applied can produce a product with good quality stably, like the room temperature bonding method of the above-mentioned embodiments. Moreover, such an operation can be executed in a shorter time than the operation time of the step S2-S3 in the above-mentioned embodiments. Therefore, according to the room temperature bonding method to which the operation is applied, the bonding resultant wafer can be produced at higher speed.

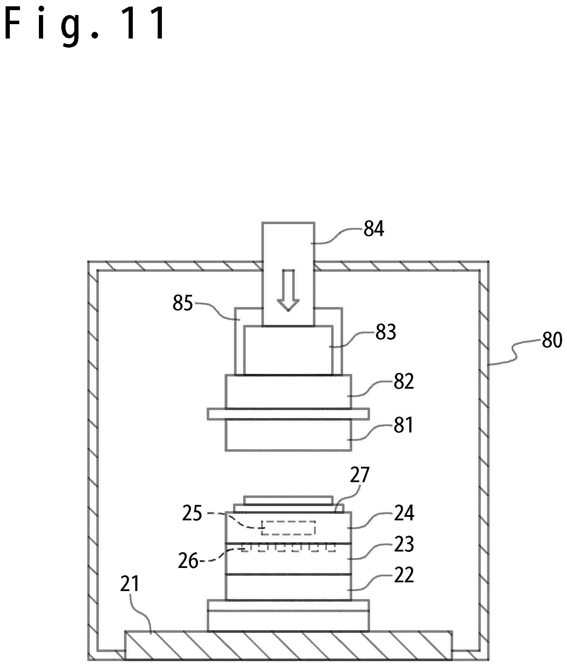

Moreover, FIG. 11 shows another heat chamber. The heat chamber 80 is provided with the chamber base 21, the heat sink 22, the adiabatic member 23, the sample stand 24 and the heater 25, like the heat chamber 3 in the above-mentioned embodiments. Moreover, the heat chamber 80 is provided with a substrate hold element 81, an angle adjusting mechanism 82, a load cell 83, a pressurization mechanism 84 and a cooling mechanism 85. The substrate hold element 81 is formed of quartz. The holding surface is formed on the side of the substrate hold element 81 which is opposite to the sample stand 24. The holding surface is formed to be flat. The side of the substrate hold element 81 opposite to the side on where the holding surface is formed is connected to the angle adjusting mechanism 82. The angle adjusting mechanism 82 is connected to the load cell 83. The load cell 83 is supported such that it can move into the perpendicular direction to the surface of the chamber base 21.

The pressurization mechanism 84 is controlled by the control unit 61 of the room temperature bonding apparatus to move the angle adjusting mechanism 82 into the perpendicular direction to the surface of the chamber base 21, that is, to move the substrate hold element 81 into the perpendicular direction to the surface of the chamber base 21. The load cell 83 is provided with a piezoelectric element, measures the load applied to the holding plane and measures the bias of the load applied to the substrate hold element 81. The load cell 83 outputs the measured load and bias to the control unit 61 of the room temperature bonding apparatus. The angle adjusting mechanism 82 is controlled by the control unit of the room temperature bonding apparatus to change the orientation of the holding plane.

The cooled coolant is always supplied from outside the heat chamber 80 to the cooling mechanism 85 and that the load cell 83 is prevented from being heated when the substrate hold element 81 is heated. In the load cell 83, when the piezoelectric element is heated, an error of the measured value sometimes becomes large. The load cell 83 can measure the load and the bias in higher accuracy by preventing from heating by the heat sink 32.

The main portion of the room temperature bonding apparatus to which the heat chamber 80 is applied can be used like the main portion of the room temperature bonding apparatus to which the heat chamber 3 in the above-mentioned embodiments is applied. Therefore, when the main portion of the room temperature bonding apparatus to which the heat chamber 80 is applied is used, the room temperature bonding method can produce a product with good quality stably, like the room temperature bonding method in the above-mentioned embodiments. Moreover, because the load cell 83 of the heat chamber 80 is cooled from a closer position than in the heat chamber 3 of the above-mentioned embodiments, the load cell 83 can be cooled surely. Therefore, the load cell 83 can measure the load and bias in higher accuracy and the controllability when the pressurization mechanism 84 is controlled such that a pressing load is applied to the bonding resultant wafer can be improved. Also, the controllability when the angle adjusting mechanism 82 is controlled such that the pressing load is uniformly applied to the bonding wear can be improved.

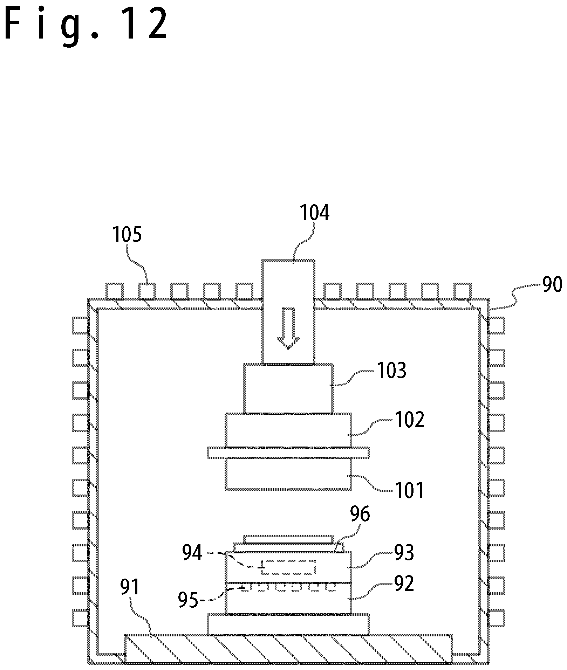

Moreover, FIG. 12 shows another heat chamber. The heat chamber 90 is provided with a chamber base 91, an adiabatic member 92, a sample stand 93 and a heater 94. The chamber base 91 is a base to form a part of the heat chamber 90 and to support the adiabatic member 92, the sample stand 93 and the heater 94. The adiabatic member 92 is formed of quartz and is fixed on the chamber base 91. The adiabatic member 92 is provided with passages 95. The passage 95 forms a conduit line through which nitrogen gas flows. The nitrogen gas is supplied from outside the heat chamber 90 by the cooling unit which is not shown. The sample stand 93 forms of aluminum nitride AlN and is fixed on the chamber base 91 through the adiabatic member 92. The holding plane 96 is formed on the side of the sample stand 93 opposite to the side which is connected to the adiabatic member 92. A holding surface 96 is formed for a cartridge to be held by the sample stand 93. The heater 94 is arranged in the inner space of the sample stand 93. The heater 94 is controlled by control unit 61 of the room temperature bonding apparatus to heat the wafer which is put on the cartridge.

Moreover, the heat chamber 90 is provided with an angle adjusting mechanism 102, a load cell 103, a pressurization mechanism 104 and a cooling unit 105, and a substrate hold element 101. The substrate hold element 101 is formed of quartz. The holding surface is formed on the side of the substrate hold element 101 opposite to the sample stand 93. The holding surface is formed to be flat. The opposite side of the substrate hold element 101 to the side on which the holding surface is formed is connected to the angle adjusting mechanism 102. The angle adjusting mechanism 102 is connected to the load cell 103. The load cell 103 is supported to be moveable into the perpendicular direction to the surface of the chamber base 21.

The pressurization mechanism 104 is controlled by the control unit 61 of the room temperature bonding apparatus to move the angle adjusting mechanism 102 into the perpendicular direction to the surface of the chamber base 21, that is, to move the substrate hold element 101 into the perpendicular direction to the surface of the chamber base 21. The load cell 103 is provided with a piezoelectric element, measures the load applied to the holding surface and measures the bias of the load applied to the substrate hold element 101. The load cell 103 outputs the load and the bias to the control unit 61 of the room temperature bonding apparatus. The angle adjusting mechanism 102 is controlled by control unit 61 of the room temperature bonding apparatus to change the direction of the holding surface.

In the cooling unit 105, the cooled coolant is always supplied from outside the heat chamber 90 to cool the heat chamber 90 and prevents that the load cell 103 is heated. The load cell 103 can measure the load and the bias in higher accuracy by preventing over-heating by the heat sink 32.

The main portion of the room temperature bonding apparatus to which the heat chamber 90 is applied can be used, like the main portion of the room temperature bonding apparatus to which the heat chamber 3 is applied in the above-mentioned embodiments. Therefore, when the main portion of the room temperature bonding apparatus to which the heat chamber 90 is applied is used, the room temperature bonding method can produce a product with good quality stably, like the room temperature bonding method in the above-mentioned embodiments. Moreover, the inner space of the heat chamber 90 can be simply formed for the heat sink 32 and the heat sink 22, as compared with the heat chamber 3 in the above-mentioned embodiments and can be made small in size.

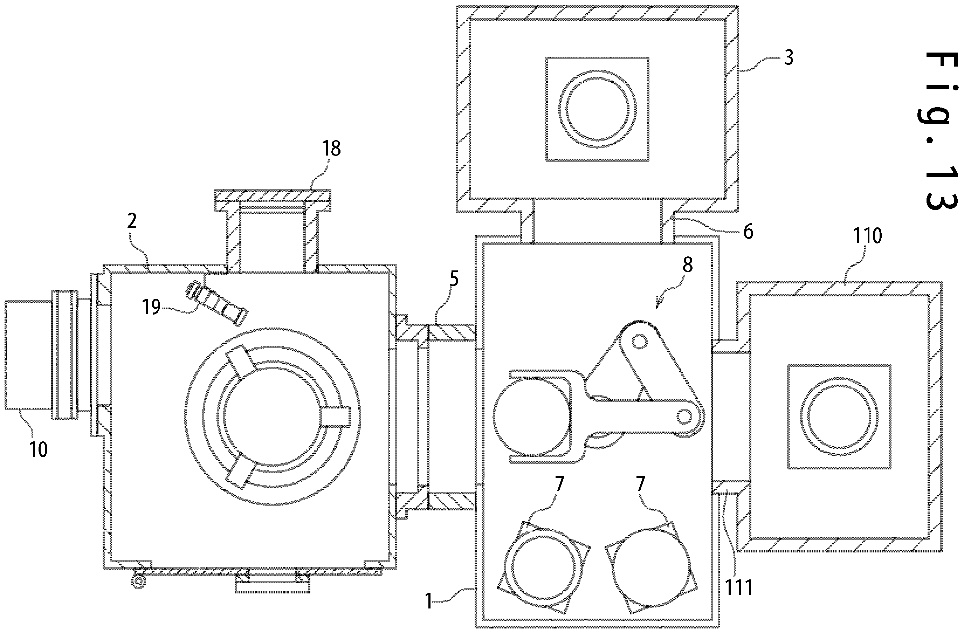

In the room temperature bonding apparatus according to another embodiment, as shown in FIG. 13, the main portion of the room temperature bonding apparatus in the above-mentioned embodiments is further provided with another heat chamber 110. The heat chamber 110 is a container in which its inner space is sealed from the environment. Moreover, the main portion of the room temperature bonding apparatus is provided with a gate valve 111. The gate valve 111 is interposed between the load lock chamber 1 and the heat chamber 110 to form a gate which connects the inner space of the heat chamber 110 and the inner space of the load lock chamber 1. The gate valve 111 is controlled by the control unit 61 of the room temperature bonding apparatus to close the gate or to open the gate.

The heat chamber 110 is provided with the chamber base 21, the heat sink 22, the adiabatic member 23, the sample stand 24 and the heater 25, like the heat chamber 3 in the above-mentioned embodiments. Moreover, the heat chamber 110 is further provided with the substrate hold element 31, the heat sink 32, the angle adjusting mechanism 33, the load cell 34 and the pressurization mechanism 35.

Another embodiment of the room temperature bonding method is added with the heat chamber 110 to the main portion of the room temperature bonding apparatus and another operation is substituted for the steps S2-S3 in the above-mentioned embodiments.

In the operation, the control unit 61 of the room temperature bonding apparatus controls the gate valve 6 such that the gate valve 6 is opened when the preliminary atmosphere is generated in the inner space of the load lock chamber 1. When the gate valve 6 is opened, the control unit 61 of the room temperature bonding apparatus controls the conveyance robot 8 such that the upper the upper cartridge 41 as one of the plurality of cartridges which are arranged in the plurality of shelves 7 is conveyed to the sample stand 24 of the heat chamber 3. Next, the control unit 61 of the room temperature bonding apparatus controls the conveyance robot 8 such that the lower cartridge 51 as one of the plurality of cartridges which are arranged in the plurality of shelves 7 is conveyed to the sample stand 24 of the heat chamber 110.

The control unit 61 of the room temperature bonding apparatus controls the gate valve 6 such that the gate valve 6 is closed after the upper cartridge 41 is held by the sample stand 24 of the heat chamber 3. When the gate valve 6 is closed, the control unit 61 of the room temperature bonding apparatus controls the vacuum pump of the heat chamber 3 such that the desorption atmosphere is generated in the inner space of the heat chamber 3. When the desorption atmosphere is generated in the inner space of the heat chamber 3, the control unit 61 of the room temperature bonding apparatus controls the heater 25 such that the upper wafer 46 put on the upper cartridge 41 is heated at a predetermined desorption temperature, that is, desorption of absorption material is carried out from the upper wafer 46. After the upper wafer 46 is heated for a predetermined time period, that is, after the desorption of the absorption material is sufficiently carried out from the upper wafer 46, the control unit 61 of the room temperature bonding apparatus controls the heater 25 such that the upper wafer 46 is not heated, and controls the cooling unit of the heat chamber 3 such that the nitrogen gas flows through the passages 26, that is, the upper wafer 46 is cooled to the bonding temperature. The control unit 61 of the room temperature bonding apparatus controls the gate valve 6 such that the gate valve 6 is opened after the desorption of the absorption material is sufficiently carried out from the upper wafer 46.

The control unit 61 of the room temperature bonding apparatus controls the gate valve 111 such that the gate valve 111 is closed after the lower cartridge 51 is held by the sample stand 24 of the heat chamber 110. The control unit 61 of the room temperature bonding apparatus controls the vacuum pump of the heat chamber 110 such that the desorption atmosphere is generated in the inner space of the heat chamber 110 when the gate valve 111 is closed. When the desorption atmosphere is generated in the inner space of the heat chamber 110, the control unit 61 of the room temperature bonding apparatus controls the heater 25 such that the lower wafer 56 put on the lower cartridge 51 is heated at the predetermined desorption temperature, that is, desorption of the absorption material is carried out from the lower wafer 56. After the lower wafer 56 is heated for a predetermined time period, that is, the desorption of the absorption material is sufficiently carried out from the lower wafer 56, the control unit 61 of the room temperature bonding apparatus controls the heater 25 such that the lower wafer 56 is not heated, and controls the cooling unit of the heat chamber 110 such that the nitrogen gas flows through the passages 26, that is, the lower wafer 56 is cooled to the bonding temperature. Next, the control unit 61 of the room temperature bonding apparatus controls the gate valve 111 such that the gate valve 111 is opened after the desorption of the absorption material is sufficiently carried out from the lower wafer 56.

The operation that the desorption of the absorption material is carried out from the lower wafer 56 is concurrently executed with the operation that the desorption of the absorption material is carried out from the upper wafer 46.

After the upper wafer 46 is cooled to the bonding temperature, the control unit 61 of the room temperature bonding apparatus controls the conveyance robot 8 such that the upper cartridge 41 is conveyed from the sample stand 24 of is the heat chamber 3 to the plurality of shelves 7. Next, the control unit 61 of the room temperature bonding apparatus controls the conveyance robot 8 such that the lower cartridge 51 is conveyed from the sample stand 24 of the heat chamber 110 to the plurality of shelves 7, after the lower wafer 56 is cooled to the bonding temperature.

The room temperature bonding method to which such an operation is applied can be produce a product with good quality stably, like the room temperature bonding method in the above-mentioned embodiments. The operation can be performed in a shorter time than the operation of the steps S2 to S3 in the above-mentioned embodiments. Therefore, according to the room temperature bonding method to which such an operation is applied, the bonding resultant wafer can be produced at higher speed.

It should be noted that the heat chamber 110 can be used for the operation (steps S7 to S8) that the bonding resultant wafer is annealed. It should be noted that when not used for the operation that the bonding resultant wafer is annealed, another heat chamber in which the substrate hold element 31, the heat sink 32, the angle adjusting mechanism 33, the load cell 34 and the pressurization mechanism 35 are omitted, is substituted for the heat chamber 110. Preferably, the main portion of the room temperature bonding apparatus to which such a heat chamber is applied is rather simpler than the main portion of the room temperature bonding apparatus to which the heat chamber 110 is applied, and the manufacturing cost is lower.

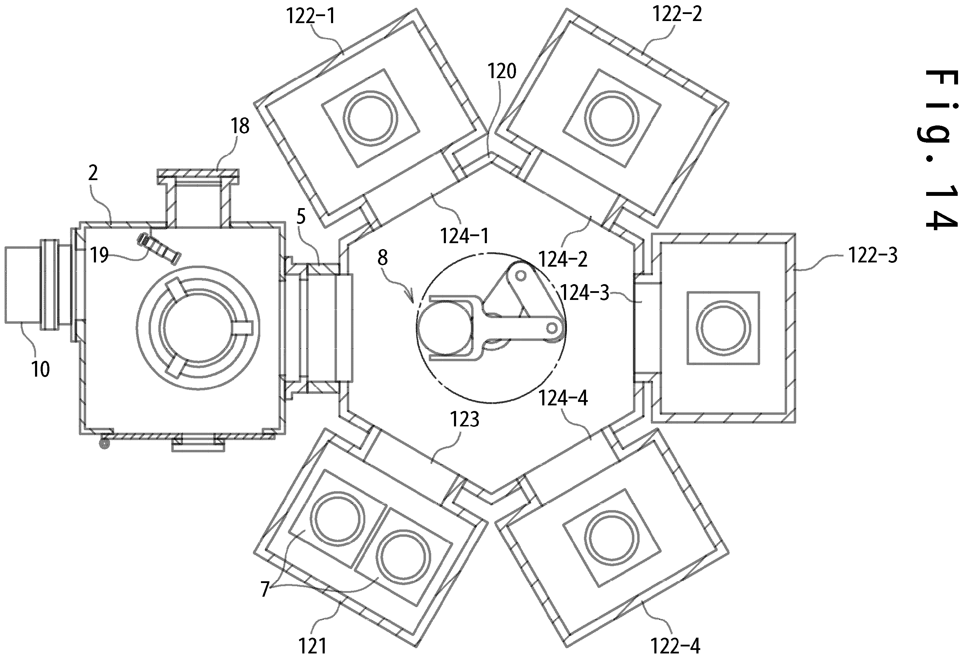

As shown in FIG. 14, in the room temperature bonding apparatus according to another embodiment, a transfer chamber 120 and a load lock chamber 121 are substituted for the load lock chamber 1 of the main portion of the room temperature bonding apparatus in the above-mentioned embodiments, and the plurality of heat chambers 122-1 to 122-4 are substituted for the heat chamber 3. The transfer chamber 120, the load lock chamber 121 and the plurality of heat chambers 122-1 to 122-4 are respectively the containers which seal the inner space from the environment. Moreover, the main portion of the room temperature bonding apparatus is provided with a gate 123 and the gate valves 124-1 to 124-4. The gate 123 is interposed between the transfer chamber 120 and the load lock chamber 121 and connects the inner space of the transfer chamber 120 and the inner space of the load lock chamber 121. The gate valve 124-i (i = 1, 2, 3, and 4) is interposed between the transfer chamber 120 and the heat chamber 122-i and forms a gate which connects the inner space of transfer chamber 120 and the inner space of the heat chamber 122-i. The gate valve 124-i is controlled by the control unit 61 of the room temperature bonding apparatus to close the gate or to open the gate.

The load lock chamber 121 is provided with a lid which is not shown. The lid closes the gate or opens the gate, which connects the environment and the inner space of the load lock chamber 121. The load lock chamber 121 is provided with a vacuum pump which is not shown. When the lid and the gate valve 121 are closed, the vacuum pump is controlled by the control unit 61 of the room temperature bonding apparatus, to exhaust gas from the inner space of the load lock chamber 121. Moreover, the load lock chamber 121 is provided with a plurality of shelves 7 therein, like the load lock chamber 1.

The transfer chamber 120 is provided with the conveyance robot 8 therein. When the gate valve 5 is opened, the conveyance robot 8 is controlled by the control unit 61 of the room temperature bonding apparatus, to convey the cartridge arranged in the plurality of shelves 7 to the bonding chamber 2, or to convey the cartridge arranged in the bonding chamber 2 to the plurality of shelves 7. Moreover, when the gate valve 124-i is opened, the conveyance robot 8 is controlled by the control unit 61 of the room temperature bonding apparatus, to convey the cartridge arranged in the plurality of shelves 7 to the heat chamber 122-i, or to convey the cartridge arranged in the heat chamber 122-i to the plurality of shelves 7.

The room temperature bonding method according to another embodiment is executed by using such a body of the room temperature bonding apparatus. In the room temperature bonding method, the other operation is substituted for the steps S2 to S3 in the above-mentioned embodiments. In the operation, the control unit 61 of the room temperature bonding apparatus controls the heat chamber 122-1 to carry out desorption of the absorption material from the upper wafer 46 and controls the heat chamber 122-2 to carry out desorption of the absorption material from the lower wafer 56. The control unit 61 of the room temperature bonding apparatus controls the heat chamber 122-3 to carry out the desorption of the absorption material from the other upper wafer 46 and the heat chamber 122-4 to carry out the desorption of the absorption material from the other lower wafer 56, while the desorption operation is carried out by using the heat chambers 122-1 and 122-2.

Moreover, in the room temperature bonding method, the other operation is substituted for steps S4 to S6. The control unit 61 of the room temperature bonding apparatus bonds the upper wafer 46 from which the absorption material is detached by using the heat chamber 122-1 and the lower wafer 56 from which the absorption material is detached by using the heat chamber 122-2 through the room temperature bonding. The control unit 61 of the room temperature bonding apparatus detaches the absorption material from another upper wafer 46 by using the heat chamber 122-1 and the absorption material from another lower wafer 56 by using the heat chamber 122-2, while the bonding resultant wafer is being produced.

Moreover, in the room temperature bonding method, another operation is substituted for the steps S7 to S8. In the operation, the control unit 61 of the room temperature bonding apparatus anneals the bonding resultant wafer by using the heat chamber 122-1. While the annealing is carried out by the heat chamber 122-1, the control unit 61 of the room temperature bonding apparatus produces the bonding resultant wafer through the room temperature bonding of the upper wafer 46 from which the absorption material is detached by using the heat chamber 122-3, and the lower wafer 56 from which the absorption material is detached by using the heat chamber 122-4.

According to the room temperature bonding method to which such an operation is applied, a product with good quality can be produced stably like the room temperature bonding method in the above-mentioned embodiments. According to the room temperature bonding method to which the operation is applied, the bonding resultant wafers can be produced more for a predetermined time period than the room temperature bonding method in the above-mentioned embodiments.

It should be noted that the present application claims a priority on convention based on Japanese Patent Application No. JP 2010-217441 which was filed on September 28, 2010.

## Claims

1. A room temperature bonding apparatus comprising:
a bonding chamber (2) comprising a bonding mechanism and configured to form a bonding resultant substrate by bonding two activated substrates by the bonding mechanism at room temperature;
a heat chamber (3) comprising a heater (25) and configured to anneal the bonding resultant substrate by using the heater (25) to reduce residual stress of the bonding resultant substrate;
**characterized by** the room temperature bonding apparatus further comprising a load lock chamber (1) comprising shelves (7) and a conveyance robot (18) in its inner space and configured to convey the bonding resultant substrate from the bonding chamber (2) into the heat chamber (3) by the conveyance robot (8), and the annealed bonding resultant substrate into the shelves (7) by the conveyance robot (8).

2. The room temperature bonding apparatus according to claim 1, further comprising a control unit (61),
wherein the heat chamber (3) comprises a pressurization mechanism configured to pressurize the bonding resultant substrate, and
wherein the control unit (61) controls the pressurization mechanism such that a load is applied to the bonding resultant substrate while the bonding resultant substrate is annealed.

3. The room temperature bonding apparatus according to claim 2, further comprising:
a sensor (34) configured to measure the load which is applied to the bonding resultant substrate when the bonding resultant substrate is annealed,
wherein the control unit (61) controls the pressurization mechanism such that the load does not reach a predetermined load or above.

4. The room temperature bonding apparatus according to claim 3, further comprising:
a chamber configured to perform desorption of absorption material from two substrates before activating the two substrates.

5. The room temperature bonding apparatus according to claim 4, further comprising:
a cooling unit configured to cool the two substrates after the desorption of the absorption material from the two substrates is performed,
wherein the control unit (61) controls the bonding chamber (2) such that the two substrates are activated after the two substrates are cooled.

6. The room temperature bonding apparatus according to claim 5, wherein the heat chamber (3) is used as the chamber.

7. The room temperature bonding apparatus according to claim 6, wherein the heat chamber (3) comprises:
a first holding device (27) configured to hold a first substrate as one of the two substrates;
a second holding device (31) configured to hold a second substrate as the other of the two substrates;
a first heater (25) configured to perform the desorption of the absorption material from the first substrate, when the first holding device (27) holds the first substrate; and
a second heater (77) configured to performs the desorption of the absorption material from the second substrate when said second holding device holds the second substrate, and
wherein, when the bonding resultant substrate is annealed by the first heater (25), the control unit (61) controls the pressurization mechanism such that the bonding resultant substrate is sandwiched by the first holding device (27) and the second holding device (31) to be pressured.

8. A room temperature bonding method
for using the room temperature bonding apparatus according to claims 1-7 comprising:
activating two substrates to prepare the two activated substrates;
bonding the two activated substrates in the bonding chamber (2) to produce the bonding resultant substrate; conveying the bonding resultant substrate from the bonding chamber (2) into the heat chamber (3) by the conveyance robot (8); and
annealing the bonding resultant substrate in the heat chamber (3) to reduce residual stress; and conveying the annealed bonding resultant substrate into the shelves (7) by the conveyance robot (8).

9. The room temperature bonding method according to claim 8, further comprising:
applying a load to the bonding resultant substrate when the annealing is performed to the bonding resultant substrate.

10. The room temperature bonding method according to claim 9, further comprising:
measuring the load applied to the bonding resultant substrate when the bonding resultant substrate is annealed; and
controlling the load such that the load is not applied to a predetermined load or above.

11. The room temperature bonding method according to claim 10, further comprising:
performing desorption of absorption material from the two substrates in a chamber before activating the two substrates.

12. The room temperature bonding method according to claim 11, further comprising:
cooling the two substrates after the desorption of the absorption material from the two substrates,
wherein the two substrates are activated in the bonding chamber (2) after said cooling.

13. The room temperature bonding method according to claim 12, wherein the annealing is performed by using the heat chamber (3) for the desorption of the absorption material from the two substrates.

14. The room temperature bonding method according to claim 13, wherein the heat chamber (3) comprises:
a first holding device (27) configured to hold a first substrate as one of the two substrates;
a second holding device (31) configured to hold a second substrate as the other of the two substrates;
wherein the heater (25) is a first heater (25) configured to perform the desorption of the absorption material from the first substrate when the first holding device (27) holds the first substrate; and
a second heater (77) configured to perform the desorption of the absorption material from the second substrate when the second holding device (31) holds the second substrate,
wherein the bonding resultant substrate is pressurized by being sandwiched between the first holding device (27) and the second holding device (31) and the annealing is performed by the first heater (25).

## Patentansprüche

1. Raumtemperatur-Bondvorrichtung, umfassend:
eine Bondkammer (2), die einen Bondmechanismus umfasst und konfiguriert ist, um ein durch Bonden erhaltenes Substrat durch Bonden zweier aktivierter Substrate durch den Bondmechanismus bei Raumtemperatur zu bilden;
eine Wärmekammer (3), die eine Heizvorrichtung (25) umfasst und konfiguriert ist, um das durch Bonden erhaltene Substrat unter Verwendung der Heizvorrichtung (25) zu tempern, um eine Eigenspannung des durch Bonden erhaltenen Substrats zu verringern;
**dadurch gekennzeichnet, dass** die Raumtemperatur-Bondvorrichtung ferner
eine Schleusenkammer (1) umfasst, die Regale (7) und einen Transportroboter (18) in ihrem Innenraum umfasst und konfiguriert ist, um das durch Bonden erhaltene Substrat mit dem Transportroboter (8) aus der Bondkammer (2) in die Wärmekammer (3) und das getemperte, durch Bonden erhaltene Substrat mit dem Transportroboter (8) in die Regale (7) zu transportieren.

2. Raumtemperatur-Bondvorrichtung nach Anspruch 1, ferner umfassend eine Steuereinheit (61),
wobei die Wärmekammer (3) einen Druckbeaufschlagungsmechanismus umfasst, der konfiguriert ist, um das durch Bonden erhaltene Substrat mit Druck zu beaufschlagen, und
wobei die Steuereinheit (61) den Druckbeaufschlagungsmechanismus so steuert, dass auf das durch Bonden erhaltene Substrat eine Last aufgebracht wird, während das durch Bonden erhaltene Substrat getempert wird.

3. Raumtemperatur-Bondvorrichtung nach Anspruch 2, ferner umfassend:
einen Sensor (34), der konfiguriert ist, um die Last, die auf das durch Bonden erhaltene Substrat aufgebracht wird, wenn das durch Bonden erhaltene Substrat getempert wird, zu messen,
wobei die Steuereinheit (61) den Druckbeaufschlagungsmechanismus so steuert, dass die Last eine vorbestimmte Last nicht erreicht oder übersteigt.

4. Raumtemperatur-Bondvorrichtung nach Anspruch 3, ferner umfassend:
eine Kammer, die konfiguriert ist, um eine Desorption von Absorptionsmaterial aus zwei Substraten durchzuführen, bevor die zwei Substrate aktiviert werden.

5. Raumtemperatur-Bondvorrichtung nach Anspruch 4, ferner umfassend:
eine Kühleinheit, die konfiguriert ist, um die zwei Substrate zu kühlen, nachdem die Desorption des Absorptionsmaterials aus den zwei Substraten durchgeführt wurde,
wobei die Steuereinheit (61) die Bondkammer (2) so steuert, dass die zwei Substrate aktiviert werden, nachdem die zwei Substrate gekühlt wurden.

6. Raumtemperatur-Bondvorrichtung nach Anspruch 5, wobei die Wärmekammer (3) als die Kammer verwendet wird.

7. Raumtemperatur-Bondvorrichtung nach Anspruch 6, wobei die Wärmekammer (3) Folgendes umfasst:
eine erste Haltevorrichtung (27), die konfiguriert ist, um ein erstes Substrat als eines der zwei Substrate zu halten;
eine zweite Haltevorrichtung (31), die konfiguriert ist, um ein zweites Substrat als das andere der zwei Substrate zu halten;
eine erste Heizvorrichtung (25), die konfiguriert ist, um die Desorption des Absorptionsmaterials aus dem ersten Substrat durchzuführen, wenn die erste Haltevorrichtung (27) das erste Substrat hält; und
eine zweite Heizvorrichtung (77), die konfiguriert ist, um die Desorption des Absorptionsmaterials aus dem zweiten Substrat durchzuführen, wenn die zweite Haltevorrichtung das zweite Substrat hält, und
wobei, wenn das durch Bonden erhaltene Substrat von der ersten Heizvorrichtung (25) getempert wird, die Steuereinheit (61) den Druckbeaufschlagungsmechanismus so steuert, dass das durch Bonden erhaltene Substrat zwischen der ersten Haltevorrichtung (27) und der zweiten Haltevorrichtung (31) eingelegt wird, um mit Druck beaufschlagt zu werden.

8. Raumtemperatur-Bondverfahren zur Verwendung der Raumtemperatur-Bondvorrichtung nach den Ansprüchen 1 - 7, umfassend:
Aktivieren von zwei Substraten, um die zwei aktivierten Substrate herzustellen;
Bonden der zwei aktivierten Substrate in der Bondkammer (2), um das durch Bonden entstandene Substrat zu erzeugen;
Transportieren des durch Bonden entstandenen Substrats von der Bondkammer (2) in die Wärmekammer (3) durch den Transportroboter (8); und
Tempern des durch Bonden erhaltenen Substrats in der Wärmekammer (3), um die Eigenspannung zu verringern; und Transportieren des getemperten, durch Bonden erhaltenen Substrats in die Regale (7) durch den Transportroboter (8).

9. Raumtemperatur-Bondverfahren nach Anspruch 8, ferner umfassend:
Aufbringen einer Last auf das durch Bonden erhaltene Substrat, wenn das Tempern des durch Bonden erhaltenen Substrats durchgeführt wird.

10. Raumtemperatur-Bondverfahren nach Anspruch 9, ferner umfassend:
Messen der Last, die auf das durch Bonden erhaltene Substrat aufgebracht wird, wenn das durch Bonden erhaltene Substrat getempert wird; und
Steuern der Last derart, dass die Last nicht bis zu einer vorbestimmten Last oder darüber aufgebracht wird.

11. Raumtemperatur-Bondverfahren nach Anspruch 10, ferner umfassend:
Durchführen der Desorption von Absorptionsmaterial aus den zwei Substraten in einer Kammer vor dem Aktivieren der zwei Substrate.

12. Raumtemperatur-Bondverfahren nach Anspruch 11, ferner umfassend:
Kühlen der zwei Substrate nach der Desorption des Absorptionsmaterials aus den zwei Substraten,
wobei die zwei Substrate in der Bondkammer (2) nach dem Kühlen aktiviert werden.

13. Raumtemperatur-Bondverfahren nach Anspruch 12, wobei das Tempern unter Verwendung der Wärmekammer (3) für die Desorption des Absorptionsmaterials aus den zwei Substraten durchgeführt wird.

14. Raumtemperatur-Bondverfahren nach Anspruch 13, wobei die Wärmekammer (3) Folgendes umfasst:
eine erste Haltevorrichtung (27), die konfiguriert ist, um ein erstes Substrat als eines der zwei Substrate zu halten;
eine zweite Haltevorrichtung (31), die konfiguriert ist, um ein zweites Substrat als das andere der zwei Substrate zu halten;
wobei die Heizvorrichtung (25) eine erste Heizvorrichtung (25) ist, die konfiguriert ist, um die Desorption des Absorptionsmaterials aus dem ersten Substrat durchzuführen, wenn die erste Haltevorrichtung (27) das erste Substrat hält; und eine zweite Heizvorrichtung (77) ist, die konfiguriert ist, um die Desorption des Absorptionsmaterials aus dem zweiten Substrat durchzuführen, wenn die zweite Haltevorrichtung (31) das zweite Substrat hält,
wobei das durch Bonden erhaltene Substrat mit Druck beaufschlagt wird, indem es zwischen der ersten Haltevorrichtung (27) und der zweiten Haltevorrichtung (31) eingelegt wird, und das Tempern von der ersten Heizvorrichtung (25) durchgeführt wird.

## Revendications

1. Dispositif de collage à température ambiante comprenant :
une chambre de collage (2) comprenant un mécanisme de collage et configurée pour former un substrat résultant du collage par collage de deux substrats activés au moyen du mécanisme de collage à la température ambiante ;
une chambre de chauffe (3) comprenant un élément chauffant (25) et configurée pour recuire le substrat résultant du collage par utilisation de l'élément chauffant (25) pour réduire la contrainte résiduelle du substrat résultant du collage ;
le dispositif de collage à température ambiante étant **caractérisé en ce qu'**il comprend en outre
une chambre de verrouillage de charge (1) comprenant des rayonnages (7) et un robot de transport (18) dans son espace intérieur et configurée pour que le substrat résultant du collage soit transporté depuis la chambre de collage (2) dans la chambre de chauffe (3) par le robot de transport (8), et que le substrat résultant du collage soit transporté dans les rayonnages (7) par le robot de transport (8).

2. Dispositif de collage à température ambiante selon la revendication 1, comprenant en outre une unité de commande (61),
dans lequel la chambre de chauffe (3) comprend un mécanisme de pressurisation configuré pour pressuriser le substrat résultant du collage, et
dans lequel l'unité de commande (61) commande le mécanisme de pressurisation de façon qu'une charge soit appliquée au substrat résultant du collage tandis que le substrat résultant du collage est recuit.

3. Dispositif de collage à température ambiante selon la revendication 2, comprenant en outre :
un capteur (34) configuré pour mesurer la charge qui est appliquée au substrat résultant du collage quand le substrat résultant du collage est recuit,
dans lequel l'unité de commande (61) commande le mécanisme de pressurisation de façon que la charge n'atteigne ou ne dépasse pas une charge prédéterminée.

4. Dispositif de collage à température ambiante selon la revendication 3, comprenant en outre :
une chambre configurée pour réaliser une désorption d'un matériau d'absorption à partir de deux substrats avant l'activation des deux substrats.

5. Dispositif de collage à température ambiante selon la revendication 4, comprenant en outre :
une unité de refroidissement configurée pour refroidir les deux substrats après que la désorption du matériau d'absorption à partir des deux substrats a été réalisée,
dans lequel l'unité de commande (61) commande la chambre de collage (2) de façon que les deux substrats soient activés après que les deux substrats ont été refroidis.

6. Dispositif de collage à température ambiante selon la revendication 5, dans lequel la chambre de chauffe (3) est utilisée en tant que chambre.

7. Dispositif de collage à température ambiante selon la revendication 6, dans lequel la chambre de chauffe (3) comprend :
un premier dispositif de maintien (27) configuré pour maintenir un premier substrat constituant l'un des deux substrats ;
un deuxième dispositif de maintien (31) configuré pour maintenir un deuxième substrat constituant l'autre des deux substrats ;
un premier élément chauffant (25) configuré pour réaliser la désorption du matériau d'absorption à partir du premier substrat, quand le premier dispositif de maintien (27) maintient le premier substrat ; et
un deuxième élément chauffant (77) configuré pour effectuer la désorption du matériau d'absorption à partir du deuxième substrat quand ledit deuxième dispositif de maintien maintient le deuxième substrat, et
dans lequel, quand le substrat résultant du collage est recuit par le premier élément chauffant (25), l'unité de commande (61) commande le mécanisme de pressurisation de façon que le substrat résultant du collage soit pris en sandwich par le premier dispositif de maintien (27) et le deuxième dispositif de maintien (31) devant être mis sous pression.

8. Procédé de collage à température ambiante pour une utilisation du dispositif de collage à température ambiante selon la revendication 1 à 7, comprenant les opérations consistant à :
activer deux substrats pour préparer les deux substrats activés ;
coller les deux substrats activés dans la chambre de collage (2) pour produire le substrat résultant du collage ;
transporter le substrat résultant du collage depuis la chambre de collage (2) dans la chambre de chauffe (3) par le robot de transport (8) ; et
recuire le substrat résultant du collage dans la chambre de chauffe (3) pour réduire la contrainte résiduelle ; et
transporter le substrat résultant du collage recuit dans les rayonnages (7) au moyen du robot de transport (8).

9. Procédé de collage à température ambiante selon la revendication 8, comprenant en outre l'opération consistant à :
appliquer une charge au substrat résultant du collage quand le recuit est réalisé sur le substrat résultant du collage.

10. Procédé de collage à température ambiante selon la revendication 9, comprenant en outre les opérations consistant à :
mesurer la charge appliquée au substrat résultant du collage quand le substrat résultant du collage est recuit ; et
contrôler la charge de façon que la charge ne soit pas appliquée à une charge prédéterminée ou au-delà.

11. Procédé de collage à température ambiante selon la revendication 10, comprenant en outre l'opération consistant à :
réaliser une désorption de matériau d'absorption à partir des deux substrats dans une chambre avant l'activation des deux substrats.

12. Procédé de collage à température ambiante selon la revendication 11, comprenant en outre l'opération consistant à :
refroidir les deux substrats après la désorption du matériau d'absorption à partir des deux substrats,
dans lequel les deux substrats sont activés dans la chambre de collage (2) après ledit refroidissement.

13. Procédé de collage à température ambiante selon la revendication 12, dans lequel le recuit est effectué par utilisation de la chambre de chauffe (3) pour la désorption du matériau d'absorption à partir des deux substrats.

14. Procédé de collage à température ambiante selon la revendication 13, dans lequel la chambre de chauffe (3) comprend :
un premier dispositif de maintien (27) configuré pour maintenir un premier substrat constituant l'un des deux substrats ;
un deuxième dispositif de maintien (31) configuré pour maintenir un deuxième substrat constituant l'autre des deux substrats ;
dans lequel l'élément chauffant (25) est
un premier élément chauffant (25) configuré pour réaliser la désorption du matériau d'absorption à partir du premier substrat quand le premier dispositif de maintien (27) maintient le premier substrat ; et
un deuxième élément chauffant (77) configuré pour effectuer la désorption du matériau d'absorption à partir du deuxième substrat quand ledit deuxième dispositif de maintien (31) maintient le deuxième substrat,
dans lequel le substrat résultant du collage est pressurisé en étant pris en sandwich entre le premier dispositif de maintien (27) et le deuxième dispositif de maintien (31) et le recuit est réalisé par le premier élément chauffant (25).
